# EUROPEAN PATENT APPLICATION

(11) **EP 4 827 266 A1**
(43) Date of publication of application: **21.10.2026**
(21) Application number: 24921507.0
(22) Date of filing: 10.10.2024
(51) Int. Cl.: H10D 1/20, H10D 62/00

(54) **INTEGRATED CIRCUIT AND MANUFACTURING METHOD THEREFOR, POWER AMPLIFICATION CIRCUIT, AND ELECTRONIC DEVICE**

(30) Priority: 31.01.2024 CN 202410142456
(71) Applicant: Huawei Technologies Co., Ltd., Shenzhen, Guangdong 518129 (CN)
(72) Inventor: WEI, Xing, Shenzhen, Guangdong 518129 (CN); ZHU, Wei, Shenzhen, Guangdong 518129 (CN); LI, Peng, Shenzhen, Guangdong 518129 (CN); ZHANG, Zhili, Shenzhen, Guangdong 518129 (CN); HE, Qiang, Shenzhen, Guangdong 518129 (CN); LI, Shuiming, Shenzhen, Guangdong 518129 (CN); MA, Ping, Shenzhen, Guangdong 518129 (CN); ZHONG, Zheng, Shenzhen, Guangdong 518129 (CN); LI, Haijun, Shenzhen, Guangdong 518129 (CN)
(74) Representative: Goddar, Heinz J.
(86) International application number: PCT/CN2024/123989
(87) International publication number: WO 2025/161483

(57) **Abstract**

Embodiments of this application relate to the field of semiconductor technologies, and provide an integrated circuit and a fabrication method therefor, a power amplifier circuit, and an electronic device, to reduce parasitic capacitance and parasitic inductance, and improve performance of the integrated circuit. The integrated circuit includes a substrate, an HEMT device, and a first matching circuit. The HEMT device includes an epitaxial layer, a gate, a first electrode, a second electrode, and a first pad. The gate, the first electrode, the second electrode, and the first pad are all located on a side that is of the epitaxial layer and that is away from the substrate, and the gate is connected to the first pad. The first matching circuit includes a first capacitor, and the first capacitor is located on the side that is of the epitaxial layer and that is away from the substrate. The first capacitor includes a first electrode plate and a second electrode plate that are disposed opposite to each other, the second electrode plate is located on a side that is of the first electrode plate and that is away from the substrate, the first electrode plate of the first capacitor is grounded, and the second electrode plate of the first capacitor is connected to the gate. The integrated circuit is used in an electronic device, to improve performance of the electronic device.

## Description

This application claims priority to Chinese Patent Application No. 202410142456.5, filed with the China National Intellectual Property Administration on January 31, 2024 and entitled "INTEGRATED CIRCUIT AND FABRICATION METHOD THEREFOR, POWER AMPLIFIER CIRCUIT, AND ELECTRONIC DEVICE", which is incorporated herein by reference in its entirety.

### TECHNICAL FIELD

This application relates to the field of semiconductor technologies, and in particular, to an integrated circuit and a fabrication method therefor, a power amplifier circuit, and an electronic device.

### BACKGROUND

As a type of wireless communication technology, a mobile communication technology is widely applied in typical scenarios such as smart transportation, environment monitoring, intelligent public facilities, remote medical diagnosis, smart manufacturing, smart home, and smart life. With the development of communication technologies, requirements on parameters such as energy consumption, efficiency, power, and a size of an electronic device are increasing accordingly.

Gallium nitride (GaN) materials have advantages such as a wide band gap, a high critical breakdown electric field, a high electron saturation speed, a high thermal conductivity, and a strong radiation resistance capability, and are widely used in the field of communication technologies. When a gallium nitride device is used in the radio frequency field, the gallium nitride device is generally packaged together with an internal matching circuit, where the internal matching circuit is configured to: optimize input impedance of the gallium nitride device and adjust a secondary harmonic position of the gallium nitride device. However, when the internal matching circuit is introduced, parasitic capacitance and parasitic inductance are increased accordingly. As a result, an integrated circuit using the internal matching circuit and the gallium nitride device cannot give full play to its excellent characteristics.

### SUMMARY

Embodiments of this application provide an integrated circuit and a fabrication method therefor, a power amplifier circuit, and an electronic device, to reduce parasitic capacitance and parasitic inductance, and improve performance of the integrated circuit.

To achieve the foregoing objectives, the following technical solutions are used in embodiments of this application.

According to a first aspect, an integrated circuit is provided. The integrated circuit includes a substrate, an HEMT device, and a first matching circuit.

The HEMT device is located on the substrate. The HEMT device includes an epitaxial layer, a gate, a first electrode, a second electrode, and a first pad, where the gate, the first electrode, the second electrode, and the first pad are all located on a side that is of the epitaxial layer and that is away from the substrate, the gate is located between the first electrode and the second electrode, and the gate is connected to the first pad.

The first matching circuit includes a first capacitor. The first capacitor is located on the side that is of the epitaxial layer and that is away from the substrate. The first capacitor includes a first electrode plate and a second electrode plate that are disposed opposite to each other, the second electrode plate is located on a side that is of the first electrode plate and that is away from the substrate, the first electrode plate of the first capacitor is grounded, and the second electrode plate of the first capacitor is connected to the gate.

In the integrated circuit provided in this embodiment of this application, the HEMT device is connected to the first matching circuit, the first capacitor of the first matching circuit is disposed on the epitaxial layer of the HEMT device, the first capacitor includes the first electrode plate and the second electrode plate, the first electrode plate is grounded, and the second electrode plate is connected to the gate of the HEMT device. In this way, no bonding wire needs to be disposed between the first capacitor in the first matching circuit and the gate, so that parasitic inductance and parasitic capacitance between the first capacitor and the gate are small, and parasitic capacitance and parasitic inductance in the integrated circuit are small. This helps enhance output power and efficiency of the integrated circuit, and improve consistency of high and low frequency performance of the integrated circuit. In addition, the parasitic inductance and the parasitic capacitance between the first capacitor and the gate are small, so that signal transmission between the first capacitor and the gate may be fast. This can mitigate a signal delay, and increase a signal transmission speed of the integrated circuit.

In addition, no bonding wire is disposed between the first capacitor and the gate, so that stability of a connection between the first capacitor and the gate can be further improved, to further enhance use stability of the integrated circuit. Certainly, no bonding wire is disposed between the first capacitor and the gate. This can further reduce costs, reduce a packaging area of the integrated circuit, shorten a packaging cycle of the integrated circuit, and improve packaging efficiency of the integrated circuit.

In some embodiments, the first pad is used as the second electrode plate of the first capacitor. In this way, the second electrode plate of the first capacitor is directly connected to the gate, and no connection trace needs to be disposed between the first capacitor and the gate. This further helps simplify the structure of the integrated circuit and reduce costs of the integrated circuit.

In some embodiments, the HEMT device further includes a second pad, the second pad is located on the side that is of the epitaxial layer and that is away from the substrate, and the gate is further connected to the second pad; and the first pad is located between the first electrode and the second pad. In this way, the first pad and the second pad are connected in parallel. This helps reduce total resistance on the first pad and the second pad, and improve performance of the HEMT device. In addition, the second pad connected to the gate is disposed, and the second pad may be further connected to another device (for example, another HEMT device or an element like a resistor, a capacitor, or an inductor) of the integrated circuit. This avoids a case in which the first electrode plate below the first pad is etched, and the first electrode plate is damaged as the first pad is connected to another device in the first matching circuit through a bonding wire, thereby ensuring a yield rate of the integrated circuit.

In some embodiments, the HEMT device further includes a third pad, the third pad is located on the side that is of the epitaxial layer and that is away from the substrate, and the third pad is located between the first electrode and the first pad; and the third pad connects the gate and the first pad.

In the HEMT device provided in this embodiment of this application, the third pad is disposed. In one aspect, the first pad and the third pad may be connected in parallel, so that total resistance of the first pad and the third pad can be reduced, and performance of the HEMT device can be improved. In another aspect, the third pad connected to the gate is disposed, and the third pad may be further connected to another device in the integrated circuit. This avoids a case in which the first electrode plate below the first pad is etched, and the first electrode plate is damaged as the first pad is connected to another device through a bonding wire, thereby ensuring a yield rate of the integrated circuit.

In some embodiments, the HEMT device includes a plurality of first electrodes, the plurality of first electrodes are arranged in a first direction parallel to the substrate, and the first capacitor is located between two adjacent first electrodes.

In this embodiment of this application, the first capacitor is disposed between two adjacent first electrodes of the HEMT device, so that areas of projections of the first capacitor and the HEMT device on the substrate may be small. This helps reduce a packaging area of the integrated circuit, and facilitates miniaturization of a power amplifier using the integrated circuit.

In some embodiments, the integrated circuit includes a plurality of HEMT devices, the plurality of HEMT devices are arranged in a first direction parallel to the substrate, the first capacitor is located between two adjacent HEMT devices, and the second electrode plate of the first capacitor is connected to first pads of the two adjacent HEMT devices.

In comparison with a solution in which the first capacitor is disposed in additional reserved space, in this embodiment of this application, the first capacitor is disposed in a gap between two adjacent HEMT devices in the first direction, and space between the two HEMT devices is effectively used. This can improve an integration degree of the integrated circuit, and further make the first capacitor be close to the HEMT device, thereby helping simplify a connection structure between the HENT device and the first capacitor, and simplifying a structure of the integrated circuit.

In some embodiments, the first electrode is used as the first electrode plate of the first capacitor. In this case, areas of projections of the first capacitor and the HEMT device on the substrate may be small. This helps reduce an occupied area of the integrated circuit, and facilitates miniaturization of a power amplifier using the integrated circuit provided in this embodiment of this application.

In some embodiments, the first electrode plate of the first capacitor is connected to the first electrode.

In some embodiments, the first electrode plate of the first capacitor includes a main body part and an extension part that are perpendicular to each other, and the extension part connects the main body part and the first electrode. At least a portion of a projection of the main body part on the substrate overlaps a projection of the second electrode plate on the substrate. At least a portion of a projection of the extension part on the substrate is located outside the projection of the second electrode plate on the substrate.

In some embodiments, the integrated circuit further includes a conductive layer, and the conductive layer is located on a side that is of the substrate and that is away from the HEMT device. The conductive layer penetrates the substrate and the epitaxial layer, and is connected to the first electrode plate of the first capacitor. In the integrated circuit provided in this embodiment of this application, the first electrode plate and the first electrode are connected to each other through the conductive layer, and are grounded through the conductive layer. This helps shorten a signal transmission path, increase a signal transmission rate, and reduce impedance in a signal transmission process.

In some embodiments, the first electrode plate of the first capacitor includes a first sublayer and a second sublayer that are stacked, the second sublayer is located on a side that is of the first sublayer and that is away from the substrate, and the first sublayer is in direct contact with the second sublayer; and the first sublayer is disposed at a same layer as the first electrode, and a material of the first sublayer is the same as a material of the first electrode.

In the integrated circuit provided in this embodiment of this application, the first electrode plate includes the first sublayer and the second sublayer that are stacked, so that a total thickness of the first electrode plate of the first capacitor may be large, and an area of a cross section of the first electrode plate may be large. This can reduce resistance of the first electrode plate and improve performance of the first capacitor. In addition, the thickness of the first electrode plate of the first capacitor is large. This further helps increase a process window, avoid damage or etching of the first electrode plate in a process of fabricating a second back hole, protect the first electrode plate, and ensure a yield rate of the integrated circuit.

In addition, the first sublayer is disposed at a same layer as the first electrode, and the material of the first sublayer is the same as the material of the first electrode, so that in a process of fabricating the integrated circuit, the first sublayer and the first electrode may be fabricated synchronously. This helps reduce fabrication costs of the integrated circuit, simplify a fabrication process of the integrated circuit, and improve fabrication efficiency of the integrated circuit.

In some embodiments, the HEMT device further includes a first inductor, the first inductor is located on the side that is of the epitaxial layer and that is away from the substrate, and the first inductor connects the gate and the first pad.

In some embodiments, the HEMT device includes a plurality of gates, the plurality of gates are arranged in the first direction parallel to the substrate, and the first inductor is connected to the plurality of gates. In this way, in one aspect, a quantity of first inductors in the HEMT device may be small, thereby helping simplify a structure of the HEMT device and reduce fabrication costs of the HEMT device. In another aspect, an inductance value of the first inductor may be increased.

In some embodiments, the first inductor includes a first trace segment and a second trace segment, and a projection of the first trace segment on the substrate intersects with a projection of the second trace segment on the substrate; the second trace segment includes a first sub-segment, a second sub-segment, and a third sub-segment that are sequentially connected; the first sub-segment and the third sub-segment each include a first conductive pattern and a second conductive pattern that are stacked, and the second conductive pattern is located on a side that is of the first conductive pattern and that is away from the substrate and is connected to the first conductive pattern; and one of the first trace segment and the second sub-segment includes a first conductive pattern, and the other includes a second conductive pattern.

In this embodiment of this application, the first inductor includes a plurality of turns of coils. The first trace segment and the second trace segment are disposed to lead out an end of an innermost coil in the plurality of turns of coils of the first inductor, so that the end of the innermost coil in the plurality of turns of coils may be connected to the gate or the first pad.

In some embodiments, the first conductive pattern is disposed at a same layer as the first electrode plate of the first capacitor, and the second conductive pattern is disposed at a same layer as the first pad.

In this way, the first conductive pattern may be fabricated synchronously with the first electrode, and the second conductive pattern may be fabricated synchronously with the first pad. This helps reduce fabrication costs of the integrated circuit, simplify a fabrication process of the integrated circuit, and improve fabrication efficiency of the integrated circuit. In addition, the second conductive pattern is disposed at a same layer as the first pad. This further helps simplify a connection structure between the first inductor and the first pad, simplify a structure of the HEMT device, further reduce fabrication costs of the integrated circuit, and reduce an occupied area of the integrated circuit.

In some embodiments, the first matching circuit further includes a second capacitor and a second inductor, both the second capacitor and the second inductor are located outside the substrate, and the second inductor connects the second capacitor and the first capacitor.

In some embodiments, the first matching circuit further includes a second capacitor and a second inductor, and both the second capacitor and the second inductor are located on the side that is of the epitaxial layer and that is away from the substrate; the second capacitor includes a third electrode plate and a fourth electrode plate that are disposed opposite to each other, and the fourth electrode plate is located on a side that is of the third electrode plate and that is away from the substrate; and the third electrode plate of the second capacitor is grounded, and the fourth electrode plate of the second capacitor is connected to the second electrode plate of the first capacitor through the second inductor.

In this way, the first capacitor, the second capacitor, and the second inductor in the first matching circuit are all disposed on the epitaxial layer. Not only a bonding wire does not need to be disposed between the first capacitor and the gate, but also a bonding wire does not need to be disposed between the second capacitor and the first capacitor, so that parasitic inductance and parasitic capacitance between the first capacitor and the gate may be small, parasitic inductance and parasitic capacitance between the second capacitor and the first capacitor may be small, and parasitic capacitance and parasitic inductance in the integrated circuit may be small. This may further enhance output power and efficiency of the integrated circuit, and improve consistency of high and low frequency performance of the integrated circuit.

In addition, the parasitic inductance and the parasitic capacitance between the first capacitor and the gate are small, and the parasitic inductance and the parasitic capacitance between the second capacitor and the first capacitor are also small. In this way, signal transmission between the first capacitor and the gate and between the first capacitor and the second capacitor may be fast. This can mitigate a signal delay, and increase a signal transmission speed of the integrated circuit.

In addition, the first capacitor, the second capacitor, and the second inductor in the first matching circuit are all disposed on the epitaxial layer. This can further improve stability of a connection between the first capacitor and the gate, a connection between the first capacitor and the second inductor, and a connection between the second capacitor and the second inductor, thereby enhancing use stability of the integrated circuit.

Certainly, no bonding wire needs to be disposed between the first capacitor and the gate, and no bonding wire needs to be disposed between the second capacitor and the first capacitor either. This can further reduce costs, reduce a packaging area of the integrated circuit, shorten a packaging cycle of the integrated circuit, and improve packaging efficiency of the integrated circuit.

In some embodiments, the third electrode plate of the second capacitor is disposed at a same layer as the first electrode plate of the first capacitor, and the fourth electrode plate of the second capacitor is disposed at a same layer as the second electrode plate of the first capacitor.

In this way, in a process of fabricating the first matching circuit, the first electrode plate of the first capacitor and the third electrode plate of the second capacitor may be fabricated synchronously, and the second electrode plate of the first capacitor and the fourth electrode plate of the second capacitor may be fabricated synchronously. This can simplify a process of fabricating the first matching circuit, improve fabrication efficiency of the first matching circuit, and reduce fabrication costs of the first matching circuit.

In some embodiments, the HEMT device further includes a fourth pad, where the fourth pad is located on the side that is of the epitaxial layer and that is away from the substrate, the first electrode is located between the first pad and the fourth pad, and the fourth pad is connected to the second electrode. The integrated circuit further includes a second matching circuit, and the second matching circuit includes a third capacitor; the third capacitor includes a fifth electrode plate and a sixth electrode plate that are disposed opposite to each other, and the sixth electrode plate is located on a side that is of the fifth electrode plate and that is away from the substrate; and the fifth electrode plate of the third capacitor is grounded, and the sixth electrode plate of the third capacitor is connected to the second electrode.

In this embodiment of this application, the HEMT device is connected to the second matching circuit, the third capacitor of the second matching circuit is disposed on the epitaxial layer of the HEMT device, the third capacitor includes the fifth electrode plate and the sixth electrode plate, the fifth electrode plate is grounded, and the sixth electrode plate is connected to the second electrode of the HEMT device. In this way, no bonding wire needs to be disposed between the third capacitor in the second matching circuit and the second electrode, so that parasitic inductance and parasitic capacitance between the third capacitor and the second electrode are small, and parasitic capacitance and parasitic inductance in the integrated circuit are small. This helps enhance output power and efficiency of the integrated circuit, and improve consistency of high and low frequency performance of the integrated circuit. In addition, the parasitic inductance and the parasitic capacitance between the third capacitor and the second electrode are small, so that signal transmission between the third capacitor and the second electrode may be fast. This can mitigate a signal delay, and increase a signal transmission speed of the integrated circuit.

In addition, no bonding wire is disposed between the third capacitor and the second electrode. This can further improve stability of a connection between the third capacitor and the second electrode, thereby enhancing use stability of the integrated circuit. Certainly, no bonding wire is disposed between the third capacitor and the second electrode. This can further reduce costs, reduce a packaging area of the integrated circuit, shorten a packaging cycle of the integrated circuit, and improve packaging efficiency of the integrated circuit.

According to a second aspect, a method for fabricating an integrated circuit is provided, where the fabrication method includes: forming an epitaxial layer on a substrate; and forming a gate, a first electrode, a second electrode, a first pad, and a first capacitor on a side that is of the epitaxial layer and that is away from the substrate, where the gate is located between the first electrode and the second electrode, and the gate is connected to the first pad; the first capacitor includes a first electrode plate and a second electrode plate that are disposed opposite to each other, the second electrode plate is located on a side that is of the first electrode plate and that is away from the substrate, the first electrode plate of the first capacitor is grounded, and the second electrode plate of the first capacitor is connected to the gate.

According to a third aspect, a power amplifier circuit is provided. The power amplifier circuit includes a package structure and the integrated circuit according to any one of the foregoing embodiments, and the integrated circuit is packaged inside the package structure.

According to a fourth aspect, an electronic device is provided. The electronic device includes a power amplifier and an antenna, where the power amplifier is configured to: amplify a radio frequency signal and then output the amplified radio frequency signal to the antenna for radiation, and the power amplifier includes the power amplifier circuit according to the foregoing embodiment.

For technical effects brought by any design manner of the second aspect and the fourth aspect, refer to technical effects brought by different design manners of the first aspect, and details are not described herein again.

### BRIEF DESCRIPTION OF DRAWINGS

To describe technical solutions in this application more clearly, the following briefly describes accompanying drawings used for describing some embodiments of this application. It is clear that the accompanying drawings in the following descriptions are merely accompanying drawings in some embodiments of this application. A person of ordinary skill in the art may further derive other drawings from these accompanying drawings. In addition, the accompanying drawings in the following descriptions may be considered as diagrams, and are not intended to limit an actual size of a product, an actual procedure of a method, an actual timing of a signal, and the like in embodiments of this application.
FIG. 1 is a diagram of a structure of an electronic device according to an embodiment of this application;
FIG. 2 is a diagram of a structure of another electronic device according to an embodiment of this application;
FIG. 3 is a diagram of a structure of a power amplifier circuit according to an embodiment of this application;
FIG. 4 is a top view of a power amplifier circuit according to an embodiment of this application;
FIG. 5 is a top view of an integrated circuit according to an embodiment of this application;
FIG. 6 is a cross-sectional view of the integrated circuit shown in FIG. 5 along line A-A';
FIG. 7 is a cross-sectional view of the integrated circuit shown in FIG. 5 along line B-B';
FIG. 8 is a cross-sectional view of the integrated circuit shown in FIG. 5 along line C-C';
FIG. 9 is a top view of another integrated circuit according to an embodiment of this application;
FIG. 10 is a top view of still another integrated circuit according to an embodiment of this application;
FIG. 11 is a top view of yet another integrated circuit according to an embodiment of this application;
FIG. 12 is a cross-sectional view of the integrated circuit shown in FIG. 11 along line D-D';
FIG. 13 is a top view of yet another integrated circuit according to an embodiment of this application;
FIG. 14 is a top view of yet another integrated circuit according to an embodiment of this application;
FIG. 15 is a cross-sectional view of the integrated circuit shown in FIG. 14 along line E-E';
FIG. 16 is a top view of yet another integrated circuit according to an embodiment of this application;
FIG. 17 is a top view of yet another integrated circuit according to an embodiment of this application;
FIG. 18 is a top view of yet another integrated circuit according to an embodiment of this application;
FIG. 19 is a top view of yet another integrated circuit according to an embodiment of this application;
FIG. 20 is a cross-sectional view of the integrated circuit shown in FIG. 19 along line H-H';
FIG. 21 is a top view of yet another integrated circuit according to an embodiment of this application;
FIG. 22 is a cross-sectional view of the integrated circuit shown in FIG. 21 along line I-I';
FIG. 23 is a top view of yet another integrated circuit according to an embodiment of this application;
FIG. 24 is a top view of yet another integrated circuit according to an embodiment of this application;
FIG. 25 is a top view of yet another integrated circuit according to an embodiment of this application;
FIG. 26 is a top view of yet another integrated circuit according to an embodiment of this application;
FIG. 27 is a top view of a first inductor or a second inductor according to an embodiment of this application;
FIG. 28 is a cross-sectional view of the first inductor or the second inductor shown in FIG. 27 along line J-J';
FIG. 29 is a cross-sectional view of the first inductor or the second inductor shown in FIG. 27 along line K-K';
FIG. 30 is a top view of yet another integrated circuit according to an embodiment of this application;
FIG. 31 is a top view of yet another integrated circuit according to an embodiment of this application;
FIG. 32 is a cross-sectional view of the integrated circuit shown in FIG. 31 along line N-N';
FIG. 33 is a top view of yet another integrated circuit according to an embodiment of this application;
FIG. 34 is a cross-sectional view of the integrated circuit shown in FIG. 33 along line F-F'; and
FIG. 35 is a fabrication flowchart of a method for fabricating an integrated circuit according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms such as "first" and "second" mentioned below in embodiments of this application are merely used for ease of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In embodiments of this application, "up", "down", "left", and "right" are not limited to definitions relative to directions in which components are schematically placed in accompanying drawings. It should be understood that these directional terms may be relative concepts used for relative description and clarification, and may change correspondingly based on a change of a direction in which a component in an accompanying drawing is placed.

In embodiments of this application, unless otherwise specified in the context, in the entire specification and claims, the term "include" is interpreted as "open and inclusive", that is, "include, but not limited to". In the descriptions of the specification, terms such as "an embodiment", "some embodiments", "example embodiments", "examples", or "some examples" are intended to indicate that specific features, structures, materials, or features related to embodiments or examples are included in at least one embodiment or example of the present disclosure. The foregoing schematic representations of the terms do not necessarily refer to a same embodiment or example. Further, the particular feature, structure, material, or characteristic may be included in any one or more embodiments or examples in any appropriate manner.

When some embodiments are described, expressions of "coupling" and its extensions may be used. For example, when some embodiments are described, the term "coupling" may indicate that two or more components are in direct physical contact or electrical contact. However, the term "coupling" may also indicate that two or more components are not in direct contact with each other, but still collaborate or interact with each other. Embodiments disclosed herein are not necessarily limited to content of this specification.

In embodiments of this application, an example implementation is described with reference to a sectional view and/or a plane diagram and/or an equivalent circuit diagram that are/is used as idealized example accompanying drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending feature. Therefore, the regions shown in the accompanying drawings are essentially examples, and their shapes are not intended to show actual shapes of regions of a device, and are not intended to limit a scope of the example implementations.

An embodiment of this application provides an electronic device. The electronic device may be, for example, different types of user equipment or terminal devices such as a lidar driver, a laser, a detector, a radar, or a 5G (the 5th generation mobile network, the 5th generation mobile communication technology) communication device. Alternatively, the electronic device may be a network device like a base station. Alternatively, the electronic device may be an apparatus like a power amplifier in the foregoing electronic device. A specific form of the electronic device is not specifically limited in embodiments of this application.

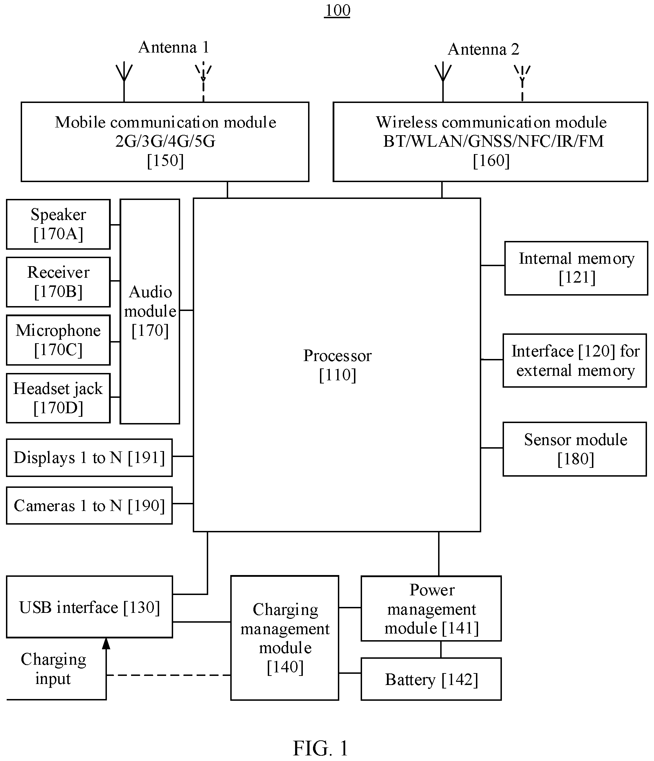

In some examples, the electronic device provided in embodiments of this application may be a mobile phone. FIG. 1 is a diagram of a structure of a mobile phone 100. The mobile phone 100 may include a processor 110, an interface 120 for external memory, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a camera 190, a display 191, and the like.

It may be understood that the structure shown in this embodiment of this application does not constitute a specific limitation on the mobile phone 100. In some other embodiments of this application, the mobile phone 100 may include more or fewer components than those shown in the figure, or some components may be combined, or some components may be split, or different component arrangements may be used. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural-network processing unit (neural-network processing unit, NPU), and/or the like. Different processing units may be independent components, or may be integrated into one or more processors.

A memory may be further disposed in the processor 110, and is configured to store instructions and data. In some embodiments, the memory in the processor 110 is a cache memory. The memory may store instructions or data just used or cyclically used by the processor 110. If the processor 110 needs to use the instructions or data again, the instructions or data may be directly invoked from the memory. This avoids repeated access, reduces waiting time of the processor 110, and improves system efficiency.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

The charging management module 140 is configured to receive charging input from a charger. The charger may be a wireless charger or a wired charger. In some embodiments of wired charging, the charging management module 140 may receive a charging input of a wired charger through the USB interface 130. In some embodiments of wireless charging, the charging management module 140 may receive a wireless charging input through a wireless charging coil of the mobile phone 100. While charging the battery 142, the charging management module 140 may further supply power to the mobile phone through the power management module 141.

The power management module 141 is configured to connect to the battery 142, the charging management module 140, and the processor 110. The power management module 141 receives an input from the battery 142 and/or the charging management module 140, and supplies power to the processor 110, the internal memory 121, the display 191, the camera 190, the wireless communication module 160, and the like. The power management module 141 may be further configured to monitor parameters such as a battery capacity, a battery cycle count, and a battery health status (electric leakage or impedance). In some other embodiments, the power management module 141 may alternatively be disposed in the processor 110. In some other embodiments, the power management module 141 and the charging management module 140 may alternatively be disposed in a same device.

A wireless communication function of the mobile phone 100 may be implemented through the antenna 1, the antenna 2, the mobile communication module 150, the wireless communication module 160, the modem processor, the baseband processor, and the like.

The antenna 1 and the antenna 2 are configured to: transmit and receive an electromagnetic wave signal. Each antenna in the mobile phone 100 may be configured to cover a single or a plurality of communication frequency bands. Different antennas may be further reused, to improve antenna utilization. For example, the antenna 1 may be reused as a diversity antenna of a wireless local area network. In some other embodiments, the antenna may be used in combination with a tuning switch.

The mobile communication module 150 may provide a wireless communication solution, including 2G/3G/4G/5G or the like, that is applied to the mobile phone 100. The mobile communication module 150 may include one or more filters, a switch, a power amplifier, a low noise amplifier (low noise amplifier, LNA), and the like. The mobile communication module 150 may receive an electromagnetic wave through the antenna 1, perform processing such as filtering or amplification on the received electromagnetic wave, and transmit the electromagnetic wave to the modem processor for demodulation. The mobile communication module 150 may further amplify a signal modulated by the modem processor, and convert the signal into an electromagnetic wave for radiation through the antenna 1. In some embodiments, at least some functional modules of the mobile communication module 150 may be disposed in the processor 110. In some embodiments, at least some functional modules of the mobile communication module 150 may be disposed in a same device as at least some modules of the processor 110.

The modem processor may include a modulator and a demodulator. The modulator is configured to modulate a to-be-sent low-frequency baseband signal into a medium-high frequency signal. The demodulator is configured to demodulate a received electromagnetic wave signal into a low-frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal through an audio device (which is not limited to the speaker 170A, the receiver 170B, or the like), or displays an image or a video through the display 191. In some embodiments, the modem processor may be an independent component. In some other embodiments, the modem processor may be independent of the processor 110, and is disposed in a same device as the mobile communication module 150 or another functional module.

The wireless communication module 160 may provide a solution to wireless communication applied to the mobile phone 100, for example, a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), near field communication (near field communication, NFC) technology, and an infrared (infrared, IR) technology. The wireless communication module 160 may be one or more components into which one or more communication processing modules are integrated. The wireless communication module 160 receives an electromagnetic wave through the antenna 2, performs frequency modulation and filtering on an electromagnetic wave signal, and sends a processed signal to the processor 110. The wireless communication module 160 may further receive a to-be-sent signal from the processor 110, perform frequency modulation and amplification on the signal, and convert the signal into an electromagnetic wave for radiation through the antenna 2.

In some embodiments, in the mobile phone 100, the antenna 1 is coupled to the mobile communication module 150, and the antenna 2 is coupled to the wireless communication module 160, so that the mobile phone 100 can communicate with a network and another device by using a wireless communication technology. The wireless communication technology may include, for example, a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), BT, a GNSS, a WLAN, NFC, FM, and/or an IR technology. The GNSS may include a global positioning system (global positioning system, GPS), a global navigation satellite system (global navigation satellite system, GLONASS), a BeiDou navigation satellite system (BeiDou navigation satellite system, BDS), a quasi-zenith satellite system (quasi-zenith satellite system, QZSS), and/or a satellite-based augmentation system (satellite-based augmentation system, SBAS).

The mobile phone 100 implements a display function through the GPU, the display 191, the application processor, and the like. The GPU is a microprocessor for image processing, and is connected to the display 191 and the application processor. The GPU is configured to: perform mathematical and geometric computation, and render an image. The processor 110 may include one or more GPUs, which execute program instructions to generate or change display information.

The display 191 is configured to display an image, a video, and the like. The display 191 includes a display panel. The display panel may be a liquid crystal display (liquid crystal display, LCD), an organic light-emitting diode (organic light-emitting diode, OLED), an active-matrix organic light emitting diode (active-matrix organic light emitting diode, AMOLED), a flexible light-emitting diode (flex light-emitting diode, FLED), a mini LED, a micro LED, a micro OLED, a quantum dot light emitting diode (quantum dot light emitting diode, QLED), or the like. In some embodiments, the mobile phone 100 may include one or N displays 191, where N is a positive integer greater than 1. The mobile phone 100 may implement a photographing function through the ISP, the camera 190, the video codec, the GPU, the display 191, the application processor, and the like.

The ISP is configured to process data fed back by the camera 190. For example, during photographing, a shutter is pressed, and light is transmitted to a photosensitive element of the camera through a lens. An optical signal is converted into an electrical signal, and the photosensitive element of the camera transmits the electrical signal to the ISP for processing, to convert the electrical signal into a visible image. The ISP may further perform algorithm optimization on noise, brightness, and complexion of the image. The ISP may further optimize parameters such as exposure and a color temperature of a photographing scenario. In some embodiments, the ISP may be disposed in the camera 190.

The camera 190 is configured to capture a static image or a video. An optical image of an object is generated through the lens, and is projected onto the photosensitive element. The photosensitive element may be a charge coupled device (charge coupled device, CCD) or a complementary metal-oxide-semiconductor (complementary metal-oxide-semiconductor, CMOS) phototransistor. The photosensitive element converts an optical signal into an electrical signal, and then transmits the electrical signal to the ISP to convert the electrical signal into a digital image signal. The ISP outputs the digital image signal to the DSP for processing. The DSP converts the digital image signal into an image signal in a standard format such as RGB or YUV. In some embodiments, the mobile phone 100 may include one or N cameras 190, where N is a positive integer greater than 1.

The interface 120 for external memory may be configured to connect to an external memory card, for example, a micro SD card, to extend a storage capability of the mobile phone 100. The external memory card communicates with the processor 110 through the interface 120 for external memory, to implement a data storage function. For example, files such as music and videos are stored in the external memory card.

The internal memory 121 may be configured to store one or more computer programs. The one or more computer programs include instructions. The processor 110 may run the instructions stored in the internal memory 121, so that the mobile phone 100 performs various functions, such as various function applications and data processing. The internal memory 121 may include a program storage region and a data storage region. The program storage region may store an operating system. The program storage region may further store one or more applications (such as Gallery or Contacts). The data storage region may store data (for example, Photos and Contacts) created during the use of the mobile phone 100, and the like. In addition, the internal memory 121 may include a high-speed random access memory, and may further include a nonvolatile memory, for example, one or more magnetic disk storage devices, a flash storage device, or a universal flash storage (universal flash storage, UFS). In some other embodiments, the processor 110 runs the instructions stored in the internal memory 121 and/or the instructions stored in the memory disposed in the processor, to enable the mobile phone 100 to perform various function applications and data processing.

The mobile phone 100 may implement an audio function like music playing or recording through the audio module 170, the speaker 170A, the receiver 170B, the microphone 170C, the headset jack 170D, the application processor, and the like.

The audio module 170 is configured to convert digital audio information into an analog audio signal for output, and is also configured to convert analog audio input into a digital audio signal. The audio module 170 may be further configured to: code and decode an audio signal. In some embodiments, the audio module 170 may be disposed in the processor 110, or some functional modules in the audio module 170 are disposed in the processor 110.

The speaker 170A, also referred to as a "loudspeaker", is configured to convert an audio electrical signal into a sound signal. The mobile phone 100 may be used to listen to music or answer a call in a hands-free mode over the speaker 170A.

The receiver 170B, also referred to as an "earpiece", is configured to convert an electrical audio signal into a sound signal. When a call is answered or voice information is received through the mobile phone 100, the receiver 170B may be put close to a human ear to listen to a voice.

The microphone 170C, also referred to as a "mike" or a "mic", is configured to convert a sound signal into an electrical signal. When making a call or sending a voice message, a user may make a sound near the microphone 170C through the mouth of the user, to input a sound signal to the microphone 170C. One or more microphones 170C may be disposed in the mobile phone 100. In some other embodiments, two microphones 170C may be disposed in the mobile phone 100, to collect a sound signal and further implement a noise reduction function. In some other embodiments, three, four, or more microphones 170C may alternatively be disposed in the mobile phone 100, to collect a sound signal, reduce noise, further identify a sound source, implement a directional recording function, and the like.

The headset jack 170D is configured to connect to a wired headset. The headset jack 170D may be a USB interface 130, or may be a 3.5 mm open mobile terminal platform (open mobile terminal platform, OMTP) standard interface or cellular telecommunication industry association of the USA (cellular telecommunication industry association of the USA, CTIA) standard interface.

The sensor module 180 may include a pressure sensor, a gyroscope sensor, a barometric pressure sensor, a magnetic sensor, an acceleration sensor, a range sensor, an optical proximity sensor, a fingerprint sensor, a temperature sensor, a touch sensor, an ambient light sensor, a bone conduction sensor, and the like.

In this embodiment of this application, the touch sensor is also referred to as a "touch component". The touch sensor may be disposed in the display 191. The touch sensor and the display 191 constitute a touchscreen, also referred to as a "touchscreen". The touch sensor is configured to detect a touch operation performed on or near the touch sensor. The touch sensor may transfer the detected touch operation to the application processor to determine a type of a touch event. Visual output related to the touch operation may be provided through the display. In some other embodiments, a touch panel of a touch sensor array including a plurality of touch sensors may be disposed on a surface of the display panel in an external mounting form. In some other embodiments, the touch sensor may alternatively be located at a position different from that of the display 191. A form of the touch sensor is not limited in embodiments of this application. For example, the touch sensor may be a component like a capacitor or a pressure-sensitive resistor.

In addition, the mobile phone 100 may further include one or more components such as a button, a motor, an indicator, and a subscriber identification module (subscriber identification module, SIM) card interface. This is not limited in embodiments of this application.

In some other embodiments, the electronic device provided in embodiments of this application may be a 5G base station. The 5G base station may be classified into different architectures such as a base band unit (base band unit, BBU)-active antenna unit (active antenna unit, AAU), a central unit-distributed unit (central unit-distributed unit, CU-DU)-AAU, a BBU-remote radio unit (remote radio unit, RRU)-antenna (antenna), a CU-DU-RRU-antenna, and an integrated 5G base station (5G node base station, gNB).

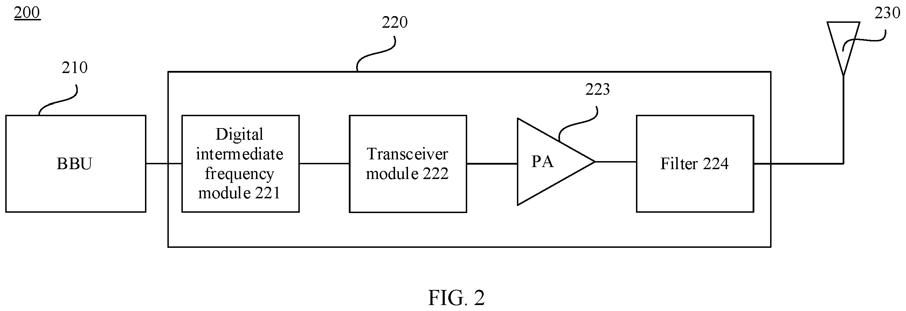

FIG. 2 shows a base station 200 with a BBU-RRU architecture. The base station 200 may include a BBU 210, an RRU 220, and an antenna 230. The BBU 210 is connected to the RRU 220 through an optical fiber, and an interface between the BBU 210 and the RRU 220 is based on an open common public radio interface (common public radio interface, CPRI) and an open base station architecture (open base station architecture initiative, OBSAI). The BBU 210 processes a generated baseband signal through the RRU 220, and then sends the processed baseband signal to the antenna 230 for transmission. The RRU 220 includes a digital intermediate frequency module 221, a transceiver module 222, a power amplifier 223 (power amplifier, PA), and a filter 224. The digital intermediate frequency module 221 is configured to perform modulation and demodulation, digital up-conversion and down-conversion, digital to analog conversion (digital to analog conversion, D/A), and the like on a baseband signal for optical fiber transmission, to form an intermediate frequency signal. The transceiver module 222 is configured to complete conversion from an intermediate frequency signal to a radio frequency signal. The power amplifier 223 is configured to amplify power of a low-power radio frequency signal. The filter 224 is configured to: filter the radio frequency signal, and then transmit the radio frequency signal through the antenna 230.

An embodiment of this application further provides a power amplifier circuit, which may be used in a power amplifier of the mobile communication module 150 or the wireless communication module 160 shown in FIG. 1, or may be used in a power amplifier of the RRU 220 in the base station 200 shown in FIG. 2. Certainly, a specific application scenario is not limited to the mobile phone 100 shown in FIG. 1 and the base station 200 shown in FIG. 2. It may be understood that any electronic device that needs to amplify a signal through a power amplifier circuit in a power amplifier belongs to an application scenario of embodiments of this application.

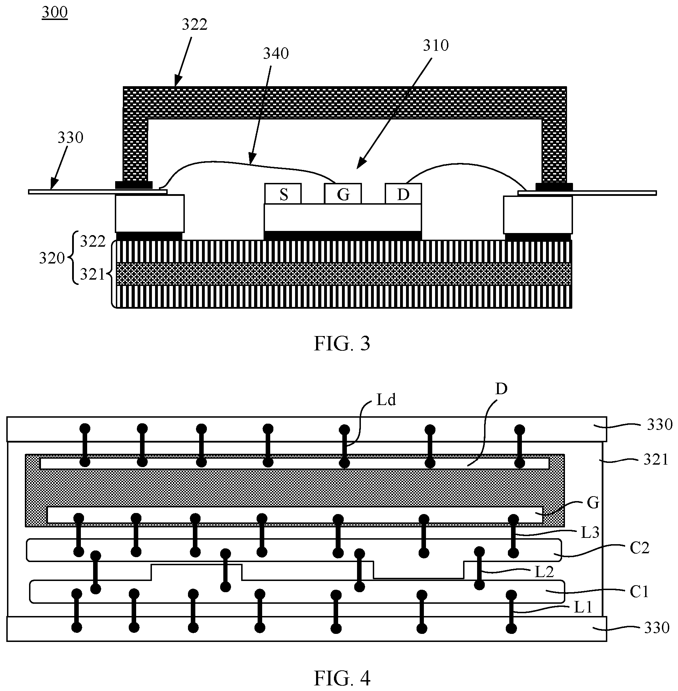

As shown in FIG. 3, a power amplifier circuit 300 may include an integrated circuit 310 and a package structure 320, where the integrated circuit 310 is packaged inside the package structure 320.

Still refer to FIG. 3. The package structure 320 may include a heat dissipation substrate 321. To improve electrical conductivity and heat dissipation performance of the heat dissipation substrate 321, the heat dissipation substrate 321 may be a laminated structure made of a composite material, for example, copper (Cu)/molybdenum (Mo)/copper. The integrated circuit 310 is bonded, by using sintered silver, to or directly welded to the heat dissipation substrate 321.

In addition, the package structure 320 may further include a package housing 322, and the package housing 322 is bonded to the heat dissipation substrate 321 by using an insulation adhesive. The integrated circuit 310 is disposed in space enclosed by the package housing 322 and the heat dissipation substrate 321. The power amplifier circuit 300 further includes a pin 330, and one end of the pin 330 is exposed from the package structure 320 to connect to another circuit.

The integrated circuit 310 may include at least one transistor, and a portion of electrodes (for example, a source S) of the transistor are connected to the heat dissipation substrate 321, to implement grounding of the source S. A portion of electrodes (for example, a drain D and a gate G) of the transistor are bonded to the pin 330 through a wire 340, the pin 330 is disposed on an insulation layer (for example, may be an insulation ceramic), and the insulation layer is bonded to the heat dissipation substrate 321 by using an insulation adhesive.

A high electron mobility transistor (high electron mobility transistor, HEMT) is a semiconductor device. Because of advantages such as a high breakdown electric field, a high channel electron concentration, a high electron mobility, and high temperature stability, the high electron mobility transistor is widely used as a transistor in the integrated circuit 310. The following provides an example for description by using an example in which the integrated circuit provided in this embodiment of this application includes an HEMT device.

As shown in FIG. 4, to enhance output power and drain efficiency of the integrated circuit, and consistency of high and low frequency performance of the integrated circuit, the integrated circuit may further include an internal matching circuit connected to the HEMT device. The internal matching circuit may include elements such as a capacitor (for example, a capacitor C1 and a capacitor C2) and an inductor (for example, an inductor L1, an inductor L2, an inductor L3, and an inductor Ld).

By disposing the internal matching circuit, input impedance can be optimized, and the device can achieve better performance. For example, when there is no internal matching circuit, a reflection coefficient (gamma value) of the integrated circuit is 0.9 during a parameter test on the integrated circuit. However, when there is an internal matching circuit, a gamma value of the integrated circuit is 0.56 during a parameter test on the integrated circuit. When the gamma value is 0.9, the integrated circuit has a large loss and a poor broadband characteristic. When the gamma value is 0.56, the integrated circuit has a small loss and a good broadband characteristic. In addition, the internal matching circuit may be disposed to further adjust a position for inputting a secondary harmonic, to optimize performance of the device.

However, because the internal matching circuit and the HEMT device are separately disposed, when the HEMT device is connected to the internal matching circuit, the HEMT device needs to be connected to the internal matching circuit through a bonding wire. The bonding wire is disposed, resulting in an increase in the parasitic inductance. In addition, a longer bonding wire indicates a larger parasitic inductance in the integrated circuit, and a greater impact of the parasitic inductance on frequency characteristics of the integrated circuit. In addition, parasitic capacitance is easily generated at an overlapping position between the bonding wire and another wire in the integrated circuit. The existence of the parasitic inductance and the parasitic capacitance severely affects the performance of the integrated circuit.

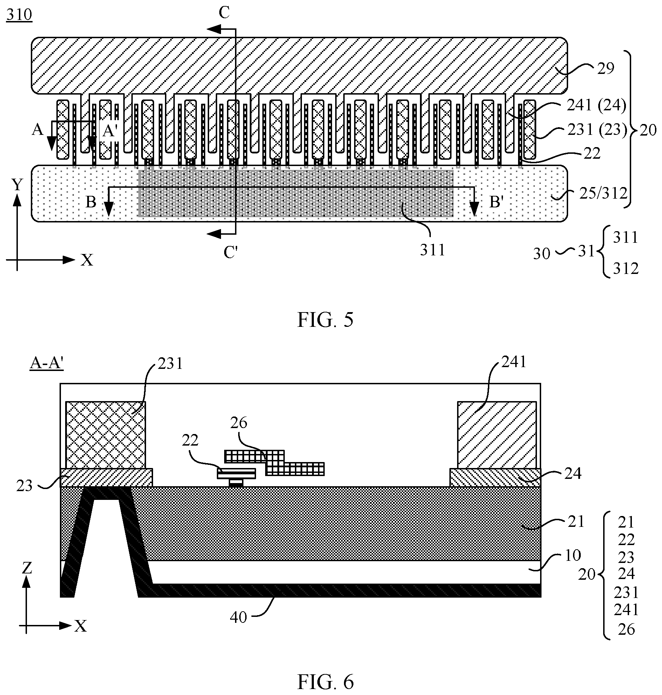

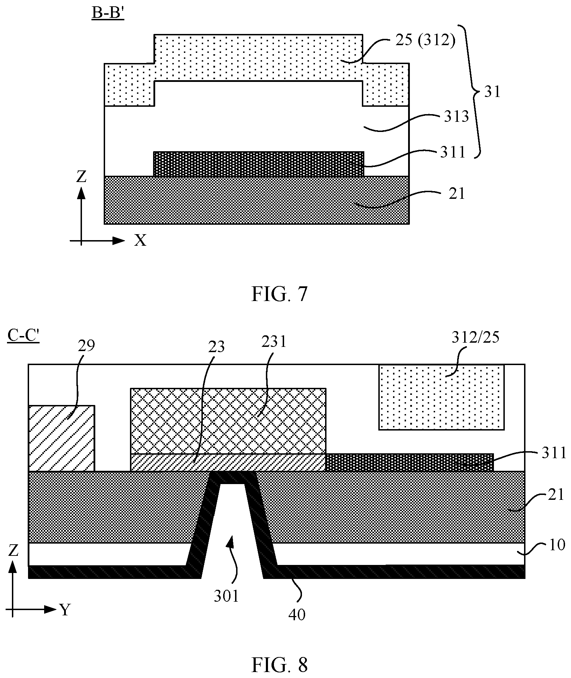

Based on this, as shown in FIG. 5 to FIG. 7, an embodiment of this application provides an integrated circuit 310. FIG. 5 is a top view of the integrated circuit 310 according to an embodiment of this application. FIG. 6 is a cross-sectional view of the integrated circuit 310 shown in FIG. 5 along line A-A'. FIG. 7 is a cross-sectional view of the integrated circuit 310 shown in FIG. 5 along line B-B'.

The integrated circuit 310 includes a substrate 10, an HEMT device 20, and a first matching circuit 30. As shown in FIG. 6, the HEMT device 20 is located on the substrate 10, and the HEMT device 20 includes an epitaxial layer 21, a gate 22, a first electrode 23, a second electrode 24, and a first pad 25. The gate 22, the first electrode 23, the second electrode 24, and the first pad 25 are all located on a side that is of the epitaxial layer 21 and that is away from the substrate 10. The gate 22 is located between the first electrode 23 and the second electrode 24, and the gate 22 is connected to the first pad 25.

As shown in FIG. 5 and FIG. 6, the gate 22, the first electrode 23, and the second electrode 24 may be alternately arranged in a first direction X parallel to the substrate 10. The first pad 25 may extend in the first direction X. The first electrode 23, the second electrode 24, and the gate 22 may all extend in a second direction Y parallel to the substrate 10. The first direction X intersects with the second direction Y. In the second direction Y, both the first electrode 23 and the second electrode 24 are located on one side of the first pad 25.

It may be understood that the first direction X is not limited to a single plane parallel to the substrate 10, and the second direction Y is also not limited to a single plane parallel to the substrate 10. In any plane parallel to the substrate 10, both the first direction X and the second direction Y may exist, and the first direction X intersects with the second direction Y. In FIG. 5, an example in which the first direction X is perpendicular to the second direction Y is used for illustration.

For example, a material of the substrate 10 may include silicon carbide (SiC), silicon (Si), sapphire, diamond, and the like.

In some examples, the epitaxial layer 21 may include a channel layer and a barrier layer that are stacked, and the barrier layer is located on a side that is of the channel layer and that is away from the substrate. A material of the channel layer is different from a material of the barrier layer, so that a heterojunction may be formed, and a two-dimensional electron gas may be generated through polarization.

For example, the material of the channel layer may include one or more of GaN, AlGaN, InAlN (indium nitride), AlN (aluminum nitride), and ScAlN (aluminum nitride). A material of the barrier layer may include, for example, one or more of GaN, AlGaN, InAlN, AlN, and ScAlN.

In some other examples, the epitaxial layer 21 may include a nucleation layer, a buffer layer, a channel layer, and a barrier layer that are sequentially away from the substrate 10. The nucleation layer is disposed to facilitate growth of an upper-layer epitaxial material (for example, a material of the buffer layer), thereby improving quality of the epitaxial layer 21. By disposing the buffer layer, stress of the epitaxial layer 21 can be alleviated, and structural stability of the HEMT device can be ensured. In addition, an anti-breakdown capability of the HEMT device can be improved, and performance of the HEMT device can be ensured.

For example, a material of the nucleation layer may include one or more of GaN, AlGaN, and AlN. A material of the buffer layer may include AlGaN and/or AlN. For example, the material of the buffer layer includes AlGaN, and a component Al in the AlGaN may decrease as a thickness increases. For another example, the material of the buffer layer includes AlGaN and AlN, and in this case, the buffer layer may be a superlattice structure.

The gate 22, the first electrode 23, and the second electrode 24 are located on the epitaxial layer 21, the gate 22 and the epitaxial layer 21 form Schottky contact, and both the first electrode 23 and the second electrode 24 form ohmic contact with the epitaxial layer 21. When the HEMT device 20 is in a working state, the first electrode 23 and the second electrode 24 can enable, under an action of an electric field, the two-dimensional electron gas to flow in a channel layer between the first electrode 23 and the second electrode 24, and conduction between the first electrode 23 and the second electrode 24 occurs at the two-dimensional electron gas in the channel layer. In the first direction X, the gate 22 is located between the first electrode 23 and the second electrode 24, and is configured to allow or hinder flow of the two-dimensional electron gas, so as to control turn-on or turn-off of the HMET device.

In some examples, the first electrode 23 may be a source, and the second electrode 24 may be a drain. In some other examples, the first electrode 23 may be a drain, and the second electrode 24 may be a source. In the following embodiments of this application, an example in which the first electrode 23 is a source and the second electrode 24 is a drain is used for description.

In some examples, as shown in FIG. 5, the HEMT device 20 may include a plurality of gates 22, a plurality of first electrodes 23, and a plurality of second electrodes 24. The plurality of gates 22, the plurality of first electrodes 23, and the plurality of second electrodes 24 are all arranged in the first direction X. When the HEMT device 20 includes a plurality of gates 22, the plurality of gates 22 are all connected to the first pad 25.

In some examples, as shown in FIG. 6, the HMET device 20 may further include a field plate (field plate, FP) 26, and the field plate 26 is located on a side that is of the gate 22 and that is away from the substrate 10. In the first direction X, an edge of a projection of the field plate 26 on the substrate 10 is closer to the second electrode 24 than an edge of a projection of the gate 22 on the substrate 10.

A material of the field plate 26 may be any conductive material. The field plate 26 may be in a floating state, and no signal is loaded. The field plate 26 may alternatively be electrically connected to the gate 22.

When the HEMT device 20 is in a working state, an electric field is generated between the gate 22 and the second electrode 24. The electric field is concentrated at a sharp corner that is of the gate 22 and that is close to the second electrode 24. Consequently, breakdown (irreversible physical damage) of the material in the epitaxial layer 21 is easily caused, and the HEMT device fails. The field plate 26 is disposed on the side that is of the gate 22 and that is away from the substrate 10, and the gate 22 extends to the side of the second electrode 24 through the field plate 26. This can change electric field distribution between the gate 22 and the second electrode 24, and direct a concentrated electric field to the sharp corner that is of the field plate 26 and that is close to the second electrode 24, rather than remaining at the sharp corner that is of the gate 22 and that is close to the second electrode 24, thereby reducing electric field strength on the side that is of the gate 22 and that is close to the second electrode 24.

Although the electric field is concentrated at one end that is of the field plate 26 and that is close to the second electrode 24, because there is a spacing between the field plate 26 and the epitaxial layer 21 in a third direction Z perpendicular to the substrate 10, the material of the epitaxial layer 21 is not easily broken down at a position that is of the epitaxial layer 21 and that is close to the second electrode 24. Therefore, a breakdown voltage of the HEMT device 20 can be increased, and reliability of the HEMT device 20 can be improved.

In some examples, as shown in FIG. 6, the HEMT device 20 may further include a first thickened electrode 231 and a second thickened electrode 241. The first thickened electrode 231 is located on a side that is of the first electrode 23 and that is away from the substrate 10, and is in contact with and connected to the first electrode 23. The second thickened electrode 241 is located on a side that is of the second electrode 24 and that is away from the substrate 10, and is in contact with and connected to the second electrode 24.

A material of the first thickened electrode 231 and a material of the second thickened electrode 241 are not limited in embodiments of this application. For example, the material of the first thickened electrode 231 may be the same as a material of the first electrode 23, and the material of the second thickened electrode 241 may be the same as a material of the second electrode 24.

The first thickened electrode 231 is disposed on the first electrode 23, and the second thickened electrode 241 is disposed on the second electrode 24. This increases thicknesses of the first electrode 23 and the second electrode 24, thereby helping reduce resistance of the first electrode 23 and the second electrode 24, and improving a current conduction capability of the HEMT device 20.

In some examples, as shown in FIG. 6, the integrated circuit 310 may further include a conductive layer 40, and the conductive layer 40 is located on a side that is of the substrate 10 and that is away from the epitaxial layer 21. The integrated circuit 310 further includes a first back hole 301, where the first back hole 301 is located below the first electrode 23 and penetrates the substrate 10 and the epitaxial layer 21. The conductive layer 40 is connected to the first electrode 23 through the first back hole 301. The first electrode 23 may be connected to the conductive layer 40 to implement grounding. In this way, mutual overlapping of wires corresponding to the first electrode 23, the gate 22, and the second electrode 24 and a length of a grounding line can be reduced, and parasitic capacitance and parasitic inductance of the HEMT device 20 can be reduced.

A material of the conductive layer 40 may include, for example, gold or titanium gold. A thickness range of the conductive layer 40 may be, for example, 500 nm to 30000 nm. The conductive layer 40 may be fabricated by using, for example, an electroplating process, an evaporation process, or a sputtering process.

As shown in FIG. 7, the first matching circuit 30 includes a first capacitor 31, and the first capacitor 31 is located on a side that is of the epitaxial layer 21 and that is away from the substrate 10. The first capacitor 31 includes a first electrode plate 311 and a second electrode plate 312 that are disposed opposite to each other, the second electrode plate 312 is located on a side that is of the first electrode plate 311 and that is away from the substrate 10, the first electrode plate 311 of the first capacitor 31 is grounded, and the second electrode plate 312 of the first capacitor 31 is connected to the gate 22. As shown in FIG. 7, the first capacitor 31 may further include a first dielectric layer 313 located between the first electrode plate 311 and the second electrode plate 312.

In this embodiment of this application, materials, thicknesses, and sizes of the first electrode plate 311, the second electrode plate 312, and the first dielectric layer 313 are not limited, and may be designed according to an actual requirement.

For example, as shown in FIG. 5, an area of a projection of the first electrode plate 311 of the first capacitor 31 on the substrate 10 may be less than an area of a projection of the second electrode plate 312 of the first capacitor 31 on the substrate 10. Alternatively, an area of a projection of the first electrode plate 311 of the first capacitor 31 on the substrate 10 may be greater than an area of a projection of the second electrode plate 312 on the substrate 10. Certainly, the area of the projection of the first electrode plate 311 of the first capacitor 31 on the substrate 10 may alternatively be equal to the area of the projection of the second electrode plate 312 of the first capacitor 31 on the substrate 10.

In the integrated circuit 310 provided in this embodiment of this application, the HEMT device 20 is connected to the first matching circuit 30, the first capacitor 31 of the first matching circuit 30 is disposed on the epitaxial layer 21 of the HEMT device 20, the first capacitor 31 includes the first electrode plate 311 and the second electrode plate 312, the first electrode plate 311 is grounded, and the second electrode plate 312 is connected to the gate 22 of the HEMT device 20. In this way, no bonding wire needs to be disposed between the first capacitor 31 in the first matching circuit 30 and the gate 22, so that parasitic inductance and parasitic capacitance between the first capacitor 31 and the gate 22 are small, and parasitic capacitance and parasitic inductance in the integrated circuit 310 are small. This helps enhance output power and efficiency of the integrated circuit 310, and improve consistency of high and low frequency performance of the integrated circuit 310. In addition, the parasitic inductance and the parasitic capacitance between the first capacitor 31 and the gate 22 are small, so that signal transmission between the first capacitor 31 and the gate 22 may be fast. This can mitigate a signal delay, and increase a signal transmission speed of the integrated circuit 310.

In addition, no bonding wire is disposed between the first capacitor 31 and the gate 22, so that stability of a connection between the first capacitor 31 and the gate 22 can be further improved, to further enhance use stability of the integrated circuit 310. Certainly, no bonding wire is disposed between the first capacitor 31 and the gate 22. This can further reduce costs, reduce a packaging area of the integrated circuit 310, shorten a packaging cycle of the integrated circuit 310, and improve packaging efficiency of the integrated circuit 310.

The following describes several disposing positions of the first capacitor 31 in embodiments of this application with reference to FIG. 5 to FIG. 20.

As shown in FIG. 5 and FIG. 6, in some embodiments, the first pad 25 is used as the second electrode plate 312 of the first capacitor 31.

In this way, the first pad 25 is used as the second electrode plate 312 of the first capacitor 31, the second electrode plate 312 of the first capacitor 31 is directly connected to the gate 22, and no connection trace needs to be disposed between the first capacitor 31 and the gate 22. This helps further simplify a structure of the integrated circuit 310 and reduce costs of the integrated circuit 310.

In some examples, as shown in FIG. 8, when the first pad 25 is used as the second electrode plate 312 of the first capacitor 31, the first electrode plate 311 of the first capacitor 31 may be disposed at a same layer as the first electrode 23. In this way, the first electrode plate 311 may be fabricated synchronously with the first electrode 23. This helps simplify a fabrication process of the integrated circuit 310 and improves fabrication efficiency.

In some other examples, when the first pad 25 is used as the second electrode plate 312 of the first capacitor 31, the first electrode plate 311 of the first capacitor 31 may alternatively be disposed at a same layer as the gate 22. In this way, the first electrode plate 311 may be fabricated synchronously with the gate 22. This helps simplify a fabrication process of the integrated circuit 310 and improves fabrication efficiency.

Certainly, when the first pad 25 is used as the second electrode plate 312 of the first capacitor 31, the first electrode plate 311 of the first capacitor 31 may not be disposed at a same layer as the gate 22 and the first electrode 23. In this case, the first electrode plate 311 of the first capacitor 31 may be fabricated separately.

A shape of the projection of the first electrode plate 311 of the first capacitor 31 on the substrate 10 and a shape of the projection of the second electrode plate 312 of the first capacitor 31 on the substrate 10 are not limited in embodiments of this application, and may be designed based on an actual situation. In FIG. 5, an example in which the shape of the projection of the second electrode plate 312 of the first capacitor 31 on the substrate 10 is a rounded rectangle is used for illustration.

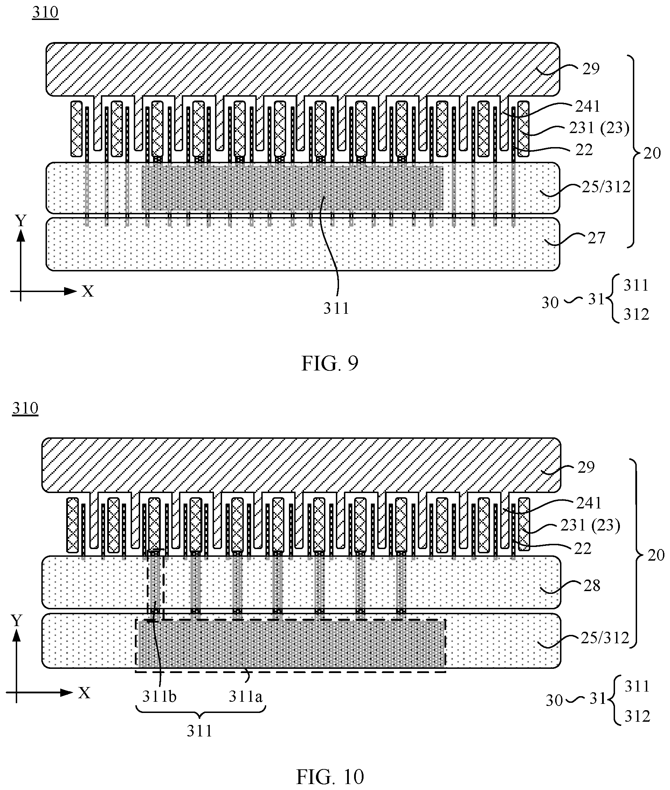

In some embodiments, as shown in FIG. 9, when the first pad 25 is used as the second electrode plate 312 of the first capacitor 31, the HEMT device 20 further includes a second pad 27, the second pad 27 is also located on a side that is of the epitaxial layer 21 and that is away from the substrate 10, and the gate 22 is further connected to the second pad 27. In the second direction Y, the first pad 25 is located between the first electrode 23 and the second pad 27.

In this way, the first pad 25 and the second pad 27 are connected in parallel. This helps reduce total resistance on the first pad 25 and the second pad 27, and improve performance of the HEMT device 20. In addition, the second pad 27 connected to the gate 22 is disposed, and the second pad 27 may be further connected to another device (for example, another HEMT device or an element like a resistor, a capacitor, or an inductor) of the integrated circuit 310. This avoids a case in which the first electrode plate below the first pad is etched, and the first electrode plate is damaged as the first pad 25 is connected to another device in the first matching circuit 30 through a bonding wire, thereby ensuring a yield rate of the integrated circuit 310.

A shape, a size, and a material of the second pad 27 are not limited in embodiments of this application. For example, as shown in FIG. 9, a shape of a projection of the second pad 27 on the substrate 10 may be the same as a shape of a projection of the first pad 25 on the substrate 10. A size of the projection of the second pad 27 on the substrate 10 may also be the same as a size of the projection of the first pad 25 on the substrate 10. A material of the second pad 27 may also be the same as that of the first pad 25.

In some examples, the second pad 27 may be disposed at a same layer as the first pad 25. In this way, the second pad 27 can be fabricated synchronously with the first pad 25, thereby simplifying a fabrication process of the HEMT device 20, improving fabrication efficiency of the integrated circuit 310, and reducing costs.

In some other embodiments, as shown in FIG. 10, when the first pad 25 is used as the second electrode plate 312 of the first capacitor 31, the HEMT device 20 may further include a third pad 28, and the third pad 28 is also located on a side that is of the epitaxial layer 21 and that is away from the substrate 10. In the second direction Y, the third pad 28 is located between the first pad 25 and the first electrode 23. The third pad 28 is connected to the gate 22 and the first pad 25.

A shape, a size, and a material of the third pad 28 are not limited in embodiments of this application. For example, as shown in FIG. 10, a shape of a projection of the third pad 28 on the substrate 10 may be the same as a shape of a projection of the first pad 25 on the substrate 10. A size of the projection of the third pad 28 on the substrate 10 may also be the same as a size of the projection of the first pad 25 on the substrate 10. The material of the third pad 28 may also be the same as that of the first pad 25.

In the HEMT device 20 provided in this embodiment of this application, the third pad 28 is disposed. In one aspect, the first pad 25 and the third pad 28 may be connected in parallel, so that total resistance of the first pad 25 and the third pad 28 can be reduced, and performance of the HEMT device 20 can be improved. In another aspect, the third pad 28 connected to the gate 22 is disposed, and the third pad 28 may be further connected to another device in the integrated circuit 310. This avoids a case in which the first electrode plate below the first pad 25 is etched, and the first electrode plate is damaged as the first pad 25 is connected to another device through a bonding wire, thereby ensuring a yield rate of the integrated circuit 310.

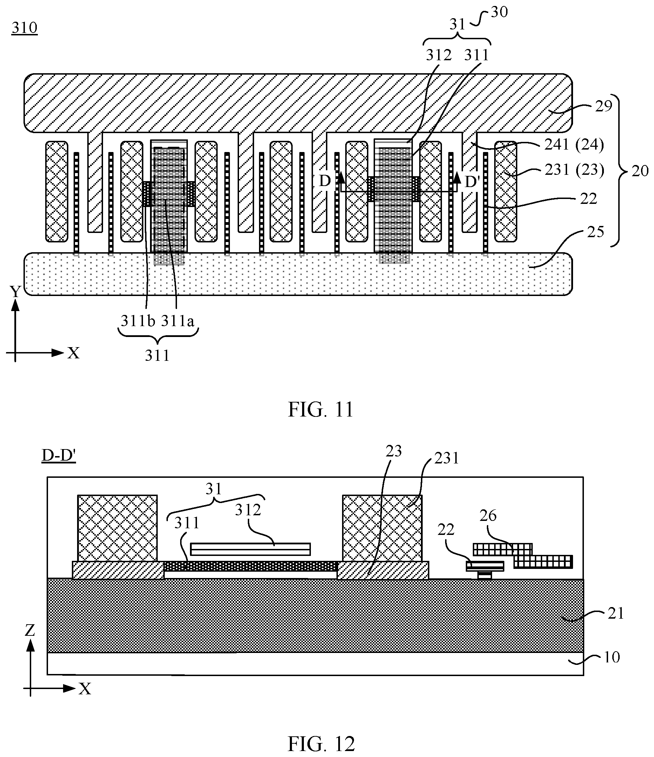

In some other embodiments, as shown in FIG. 11, the HEMT device 20 includes a plurality of first electrodes 23, the plurality of first electrodes 23 are arranged in a first direction X parallel to the substrate 10, and the first capacitor 31 is located between two adjacent first electrodes 23.

A quantity of first electrodes 23 is not limited in embodiments of this application, and may be designed according to an actual requirement. In some examples, the first matching circuit 30 may include one first capacitor 31. In some other examples, as shown in FIG. 11, the first matching circuit 30 may include a plurality of first capacitors 31. It may be understood that FIG. 11 is described by using an example in which the first matching circuit 30 includes two first capacitors 31. This does not limit a quantity of first capacitors 31 in the first matching circuit 30.

In this embodiment of this application, the first capacitor 31 is disposed between two adjacent first electrodes 23 of the HEMT device 20, so that areas of projections of the first capacitor 31 and the HEMT device 20 on the substrate 10 may be small. This helps reduce a packaging area of the integrated circuit 310, and facilitates miniaturization of a power amplifier using the integrated circuit 310.

For example, as shown in FIG. 12, the first electrode plate 311 of the first capacitor 31 may be disposed at a same layer as the gate 22. In this way, the first electrode plate 311 can be fabricated synchronously with the gate 22, thereby simplifying a fabrication process of the HEMT device 20, improving fabrication efficiency of the integrated circuit 310, and reducing costs.

For example, as shown in FIG. 12, the second electrode plate 312 of the first capacitor 31 may be disposed at a same layer as the field plate 26. In this way, the second electrode plate 312 can be fabricated synchronously with the field plate 26, thereby simplifying a fabrication process of the HEMT device 20, improving fabrication efficiency of the integrated circuit 310, and reducing costs.

It may be understood that, disposing positions of the first electrode plate 311 and the second electrode plate 312 of the first capacitor 31 are not limited in embodiments of this application.

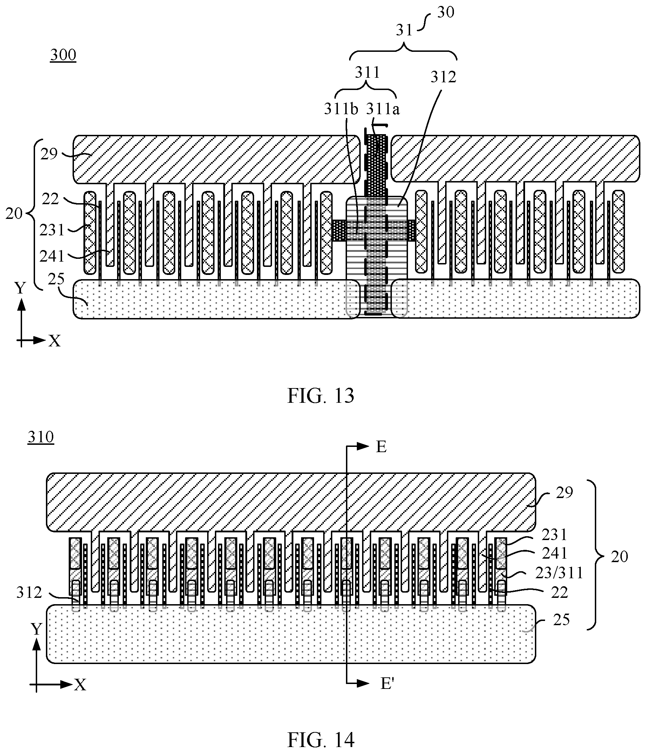

In some other embodiments, as shown in FIG. 13, the integrated circuit 310 includes a plurality of HEMT devices 20, the plurality of HEMT devices 20 may be arranged in a first direction X parallel to the substrate 10, and the first capacitor 31 is located between two adjacent HEMT devices 20. The second electrode plate 312 of the first capacitor 31 is connected to first pads 25 of two adjacent HEMT devices 20.

In comparison with a solution in which the first capacitor 31 is disposed in additional reserved space, in this embodiment of this application, the first capacitor 31 is disposed in a gap between two adjacent HEMT devices 20 in the first direction X, and space between the two HEMT devices 20 is effectively used. This can improve an integration degree of the integrated circuit 310, and further make the first capacitor 31 be close to the HEMT device 20, thereby helping simplify a connection structure between the HENT device 20 and the first capacitor 31, and simplifying a structure of the integrated circuit 310.

In some examples, as shown in FIG. 12, the first electrode plate 311 of the first capacitor 31 may be disposed at a same layer as the gate 22, and the second electrode plate 312 of the first capacitor 31 may be disposed at a same layer as the field plate 26. It may be understood that, disposing positions of the first electrode plate 311 and the second electrode plate 312 of the first capacitor 31 are not limited in embodiments of this application.

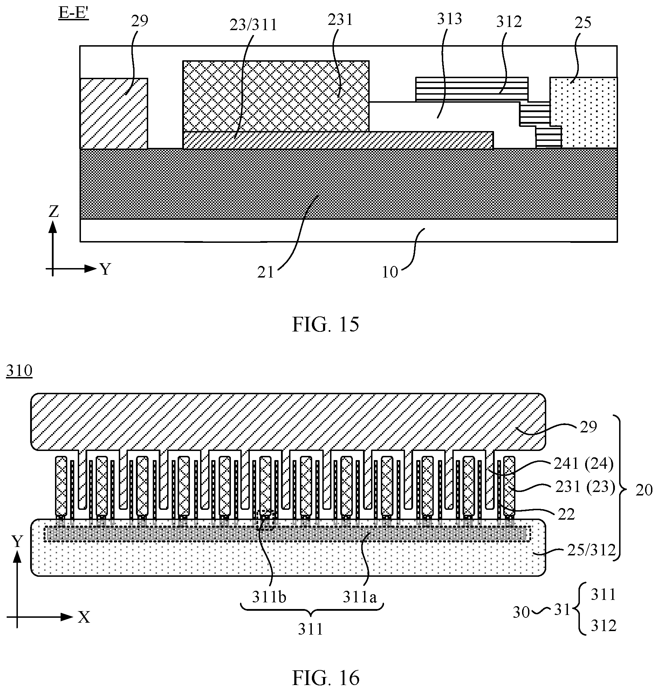

In some embodiments, the first electrode 23 may be grounded. In this case, to ground the first electrode plate 311 of the first capacitor 31, in some examples, as shown in FIG. 8, FIG. 10, FIG. 11, and FIG. 13, the first electrode 23 may be connected to the first electrode plate 311 of the first capacitor 31. Alternatively, in some other examples, as shown in FIG. 14 and FIG. 15, the first electrode 23 may be directly used as the first electrode plate 311 of the first capacitor 31.

When the first electrode 23 is used as the first electrode plate 311 of the first capacitor 31, areas of projections of the first capacitor 31 and the HEMT device 20 on the substrate 10 may be small. This helps reduce an occupied area of the integrated circuit 310, and facilitates miniaturization of a power amplifier using the integrated circuit 310 provided in this embodiment of this application.

As shown in FIG. 15, when the first electrode 23 is used as the first electrode plate 311 of the first capacitor 31, the second electrode plate 312 of the first capacitor 31 may be short-circuited to the first pad 25, so as to be connected to the gate 22.

Refer to FIG. 14 and FIG. 15. The second electrode plate 312 and the first pad 25 may be located at different layers. In this case, a projection of the second electrode plate 312 of the first capacitor 31 on the substrate 10 may partially overlap a projection of the first pad 25 on the substrate 10. Alternatively, the second electrode plate 312 and the first pad 25 may be of an integrated structure.

When the first electrode plate 311 of the first capacitor 31 is connected to the first electrode 23, as shown in FIG. 10, FIG. 11, and FIG. 13, the first electrode plate 311 of the first capacitor 31 includes a main body part 311a and an extension part 311b that are perpendicular to each other, and the extension part 311b is connected to the first electrode 23. At least a portion of a projection of the main body part 311a on the substrate 10 overlaps a projection of the second electrode plate 312 of the first capacitor 31 on the substrate 10. At least a portion of a projection of the extension part 311b on the substrate 10 is located outside the projection of the second electrode plate 312 of the first capacitor 31 on the substrate 10.

That "at least a portion of the projection of the main body part 311a on the substrate 10 overlaps a projection of the second electrode plate 312 of the first capacitor 31 on the substrate 10" may be, as shown in FIG. 11 and FIG. 13, that a portion of the projection of the main body part 311a on the substrate 10 overlaps the projection of the second electrode plate 312 of the first capacitor 31 on the substrate 10, and another portion of the projection of the main body part 311a on the substrate 10 is located outside the projection of the second electrode plate 312 of the first capacitor 31 on the substrate 10.

Alternatively, that "at least a portion of the projection of the main body part 311a on the substrate 10 overlaps a projection of the second electrode plate 312 of the first capacitor 31 on the substrate 10" may be, as shown in FIG. 10, that the projection of the main body part 311a on the substrate 10 is located inside the projection of the second electrode plate 312 of the first capacitor 31 on the substrate 10.

The foregoing description that "at least a portion of the projection of the extension part 311b on the substrate 10 is located outside the projection of the second electrode plate 312 of the first capacitor 31 on the substrate 10" may be, as shown in FIG. 10, FIG. 11, and FIG. 13, that a portion of the projection of the extension part 311b on the substrate 10 is located outside the projection of the second electrode plate 312 of the first capacitor 31 on the substrate 10, and another portion of the projection of the extension part 311b on the substrate 10 is located inside the projection of the second electrode plate 312 of the first capacitor 31 on the substrate 10.

Certainly, that "at least a portion of the projection of the extension part 311b on the substrate 10 is located outside the projection of the second electrode plate 312 of the first capacitor 31 on the substrate 10" may alternatively be that all the projection of the extension part 311b on the substrate 10 is located outside the projection of the second electrode plate 312 of the first capacitor 31 on the substrate 10.

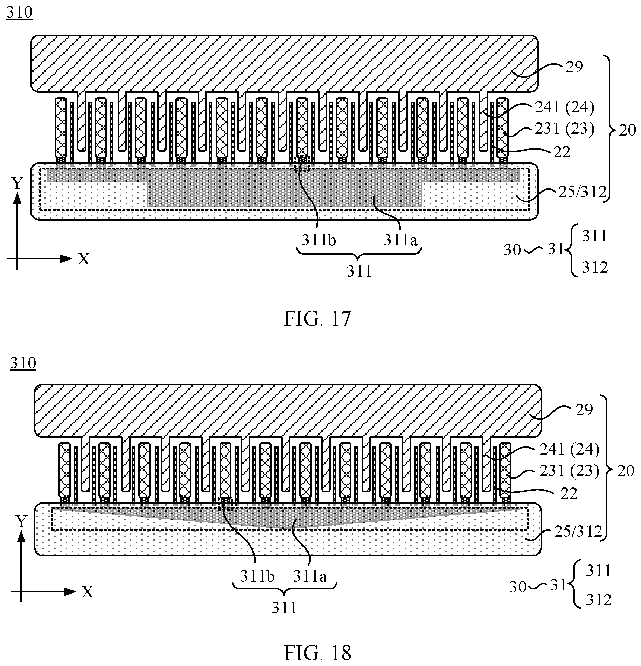

In some examples, as shown in FIG. 16, the projection of the main body part 311a on the substrate 10 may be in a rectangular shape. In some other examples, as shown in FIG. 17, the projection of the main body part 311a on the substrate 10 may be in a step shape. In some other examples, as shown in FIG. 18, the projection of the main body part 311a on the substrate 10 may be in a triangular shape. Certainly, the shape of the projection of the main body part 311a on the substrate 10 provided in this embodiment of this application is not limited thereto. Refer to FIG. 16, FIG. 17, and FIG. 18. The projection of the extension part 311b on the substrate 10 may be in a rectangular shape.

As shown in FIG. 16 to FIG. 18, the HEMT device 20 may include a plurality of first electrodes 23, the first electrode plate 311 may include a main body part 311a and a plurality of extension parts 311b, and one first electrode 23 may correspond to one extension part 311b.

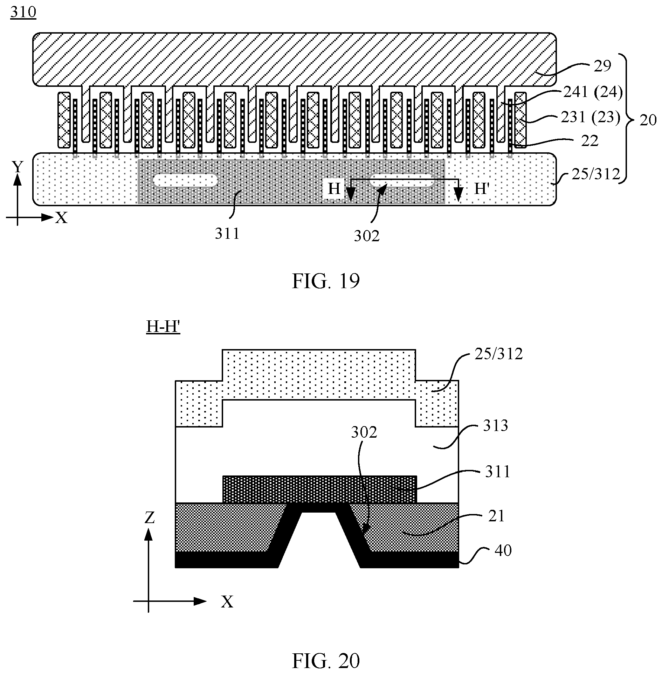

In some embodiments, as shown in FIG. 19 and FIG. 20, the integrated circuit 310 may further include a conductive layer 40. The conductive layer 40 is located on a side that is of the substrate 10 and that is away from the HEMT device 20, and the conductive layer 40 penetrates the substrate 10 and the epitaxial layer 21, and is connected to the first electrode plate 311 of the first capacitor 31.

It can be learned from the foregoing embodiment that the conductive layer 40 is further connected to the first electrode 23. Therefore, when the conductive layer 40 is connected to the first electrode plate 311, the first electrode plate 311 may be connected to the first electrode 23.

In the integrated circuit 310 provided in this embodiment of this application, the first electrode plate 311 and the first electrode 23 are connected to each other through the conductive layer 40, and are grounded through the conductive layer 40. This helps shorten a signal transmission path, increase a signal transmission rate, and reduce impedance in a signal transmission process.

As shown in FIG. 19 and FIG. 20, the integrated circuit 310 may further include a second back hole 302, where the second back hole 302 is located below the first electrode plate 311 of the first capacitor 31, and penetrates the substrate 10 and the epitaxial layer 21. The conductive layer 40 is connected to the first electrode plate 311 through the second back hole 302.

A quantity, sizes, and opening shapes of second back holes 302 are not limited in embodiments of this application. FIG. 19 is described by using an example in which one first electrode plate 311 corresponds to two second back holes 302, and an opening shape of the second back hole 302 is in a bar shape.

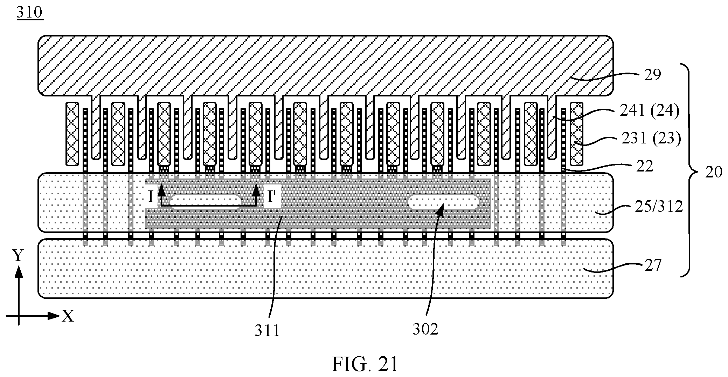

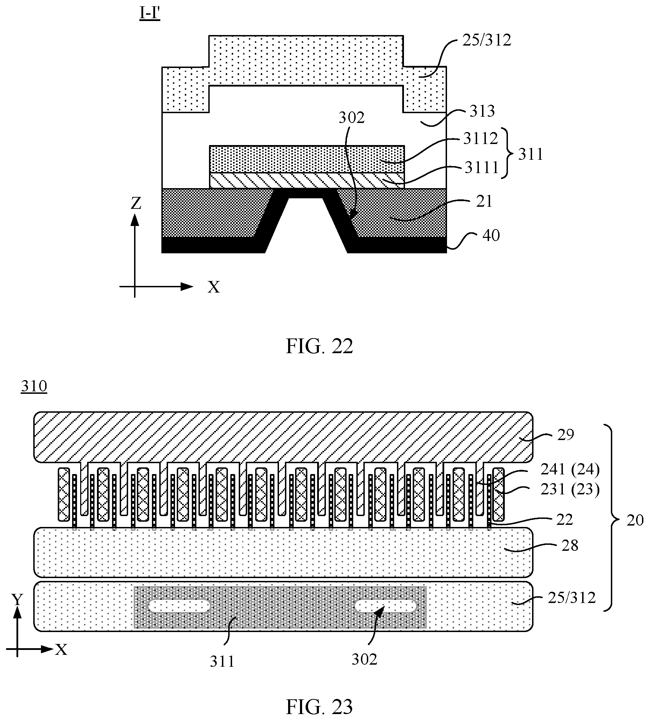

In some examples, as shown in FIG. 21 and FIG. 22, the first electrode plate 311 of the first capacitor 31 includes a first sublayer 3111 and a second sublayer 3112 that are stacked, the second sublayer 3112 is located on a side that is of the first sublayer 3111 and that is away from the substrate 10, and the first sublayer 3111 is in direct contact with the second sublayer 3112. The first sublayer 3111 is disposed at a same layer as the first electrode 23, and a material of the first sublayer 3111 is the same as a material of the first electrode 23.

A specific thickness of the first sublayer 3111 and the second sublayer 3112 is not limited in embodiments of this application, and may be designed according to an actual requirement. For example, a thickness of the first sublayer 3111 may be the same as a thickness of the second sublayer 3112. Alternatively, a thickness of the first sublayer 3111 may be greater than a thickness of the second sublayer 3112. Alternatively, a thickness of the first sublayer 3111 may be less than a thickness of the second sublayer 3112.

In the integrated circuit 310 provided in this embodiment of this application, the first electrode plate 311 includes the first sublayer 3111 and the second sublayer 3112 that are stacked, so that a total thickness of the first electrode plate 311 of the first capacitor 31 may be large, and an area of a cross section of the first electrode plate 311 may be large. This can reduce resistance of the first electrode plate 311 and improve performance of the first capacitor 31. In addition, the thickness of the first electrode plate 311 of the first capacitor 31 is large. This further helps increase a process window, avoid damage or etching of the first electrode plate 311 in a process of fabricating the second back hole 302, protect the first electrode plate 311, and ensure a yield rate of the integrated circuit 310.

In addition, the first sublayer 3111 is disposed at a same layer as the first electrode 23, and the material of the first sublayer 3111 is the same as the material of the first electrode 23, so that in a process of fabricating the integrated circuit 310, the first sublayer 3111 and the first electrode 23 may be fabricated synchronously. This helps reduce fabrication costs of the integrated circuit 310, simplify a fabrication process of the integrated circuit 310, and improve fabrication efficiency of the integrated circuit 310.

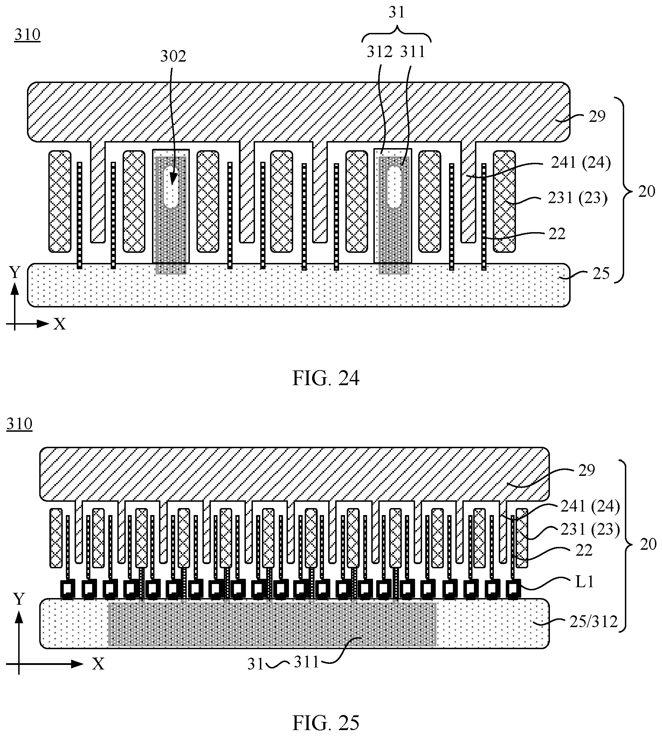

FIG. 23 and FIG. 24 are respectively top views of two integrated circuits 310 according to an embodiment of this application. Compared with the structure of the integrated circuit 310 shown in FIG. 21, the HEMT device 20 shown in FIG. 23 includes a third pad 28. In comparison with the structure of the integrated circuit 310 shown in FIG. 19, in the integrated circuit 310 shown in FIG. 24, the HEMT device 20 includes a plurality of first electrodes 23, the plurality of first electrodes 23 are arranged in a first direction X, and the first capacitor 31 is disposed between two adjacent first electrodes 23. Certainly, when the first capacitor 31 is located between two adjacent HEMT devices 20, the first electrode plate 311 of the first capacitor 31 may alternatively be grounded through the conductive layer 40 and the second back hole 302.

In some embodiments, as shown in FIG. 25, the HEMT device 20 further includes a first inductor L1, where the first inductor L1 is located on a side that is of the epitaxial layer 21 and that is away from the substrate 10, and the first inductor L1 connects the gate 22 and the first pad 25.

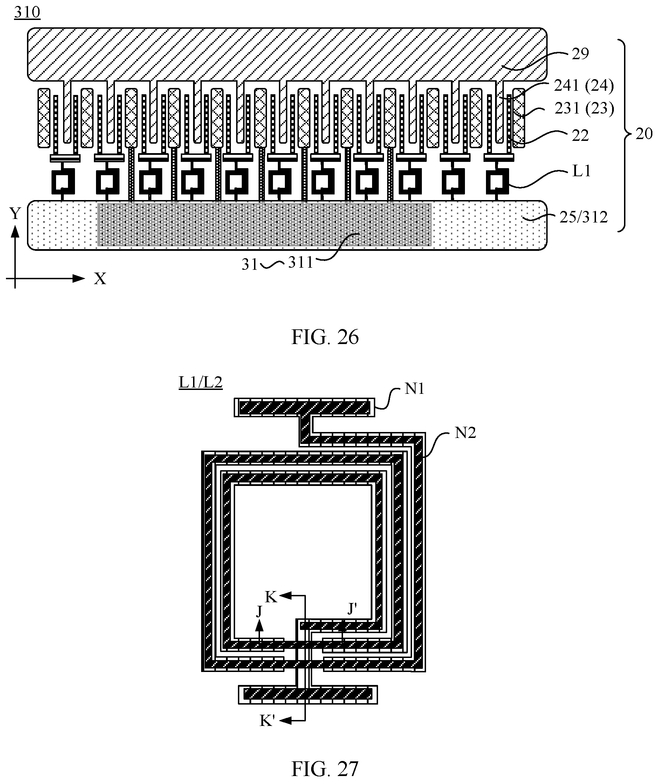

In some examples, as shown in FIG. 26, the HEMT device 20 includes a plurality of gates 22, the plurality of gates 22 are arranged in a first direction X parallel to the substrate 10, and the first inductor L1 is connected to the plurality of gates 22. A quantity of gates 22 connected to the first inductor L1 is not limited in embodiments of this application. For example, one first inductor L1 may be connected to two gates 22, three gates 22, four gates 22, or the like. FIG. 26 illustrates an example in which one first inductor L1 is connected to two gates 22.

In some examples, as shown in FIG. 26, different first inductors L1 may be connected to a same quantity of gates 22. In some other examples, different first inductors L1 may be connected to different quantities of gates 22. In some other examples, a quantity of gates 22 connected to a portion of the plurality of first inductors L1 is the same, and a quantity of gates 22 connected to another portion of the plurality of first inductors L1 may be different.

In this embodiment of this application, the first inductor L1 is connected to a plurality of gates 22. In one aspect, a quantity of first inductors L1 in the HEMT device 20 may be small, thereby helping simplify a structure of the HEMT device 20 and reducing fabrication costs of the HEMT device 20. In another aspect, an inductance value of the first inductor L1 may be increased.

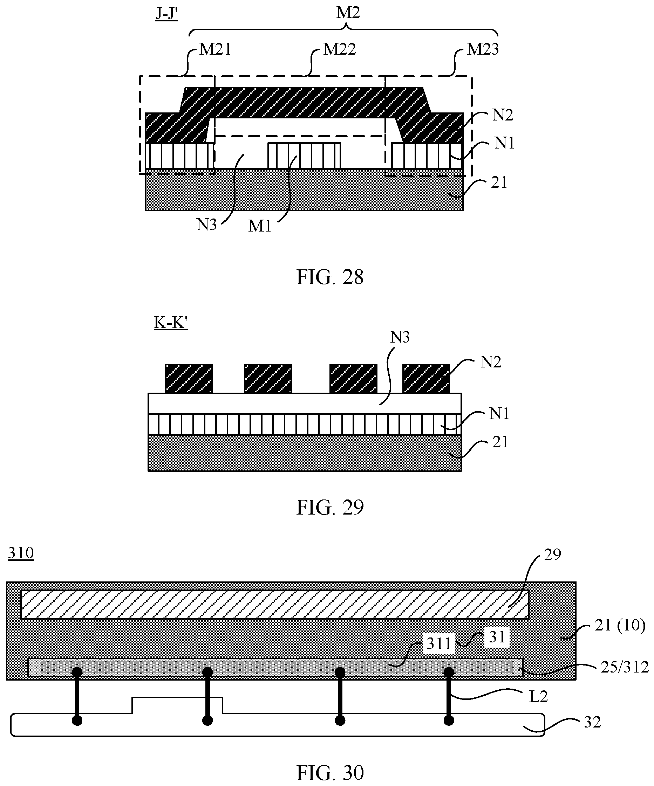

FIG. 27 is a top view of a structure of a first inductor L1 according to an embodiment of this application. FIG. 28 is a cross-sectional view of the first inductor L1 provided in FIG. 27 along line J-J'. FIG. 29 is a cross-sectional view of the first inductor L1 provided in FIG. 27 along line K-K'.

As shown in FIG. 28, in some examples, the first inductor L1 includes a first trace segment M1 and a second trace segment M2, and a projection of the first trace segment M1 on the substrate 10 intersects with a projection of the second trace segment M2 on the substrate 10. The second trace segment M2 includes a first sub-segment M21, a second sub-segment M22, and a third sub-segment M23 that are sequentially connected. The first sub-segment M21 and the third sub-segment M23 each include a first conductive pattern N1 and a second conductive pattern N2 that are stacked. The second conductive pattern N2 is located on a side that is of the first conductive pattern N1 and that is away from the substrate 10, and is connected to the first conductive pattern N1. One of the first trace segment M1 and the second sub-segment M22 includes the first conductive pattern N1, and the other includes the second conductive pattern N2. In FIG. 28, an example in which the first trace segment M1 includes the first conductive pattern N1 and the second sub-segment M22 includes the second conductive pattern N2 is used for illustration.

In some examples, a projection of the first trace segment M1 on the substrate 10 may be perpendicular to a projection of the second trace segment M2 on the substrate 10.

As shown in FIG. 27, the first inductor L1 includes a plurality of turns of coils. The first trace segment M1 and the second trace segment M2 are disposed to lead out one end of an innermost coil in the plurality of turns of coils of the first inductor L1, so that the end of the innermost coil in the plurality of turns of coils may be connected to the gate 22 or the first pad 25.

As shown in FIG. 27 and FIG. 29, in the first inductor L1, in addition to the first trace segment M1 and the second trace segment M2, all other trace segments include the first conductive pattern N1 and a second conductive pattern N2 that are stacked, and the first conductive pattern N1 and the second conductive pattern N2 are insulated from each other. The first inductor L1 may further include an insulation layer N3 located between the first conductive pattern N1 and the second conductive pattern N2.

In some examples, the first conductive pattern N1 may be disposed at a same layer as the first electrode 23, and the second conductive pattern N2 may be disposed at a same layer as the first pad 25.

In this way, the first conductive pattern N1 may be fabricated synchronously with the first electrode 23, and the second conductive pattern N2 may be fabricated synchronously with the first pad 25. This helps reduce fabrication costs of the integrated circuit 310, simplify a fabrication process of the integrated circuit 310, and improve fabrication efficiency of the integrated circuit 310. In addition, the second conductive pattern N2 is disposed at a same layer as the first pad 25. This further helps simplify a connection structure between the first inductor L1 and the first pad 25, simplify a structure of the HEMT device, further reduce fabrication costs of the integrated circuit 310, and reduce an occupied area of the integrated circuit 310.

In some embodiments, as shown in FIG. 30, the first matching circuit 30 further includes a second capacitor 32 and a second inductor L2, where both the second capacitor 32 and the second inductor L2 are located outside the substrate 10, and the second inductor L2 connects the second capacitor 32 and the first capacitor 31.

The second inductor 33 may be, for example, a bonding wire inductor.

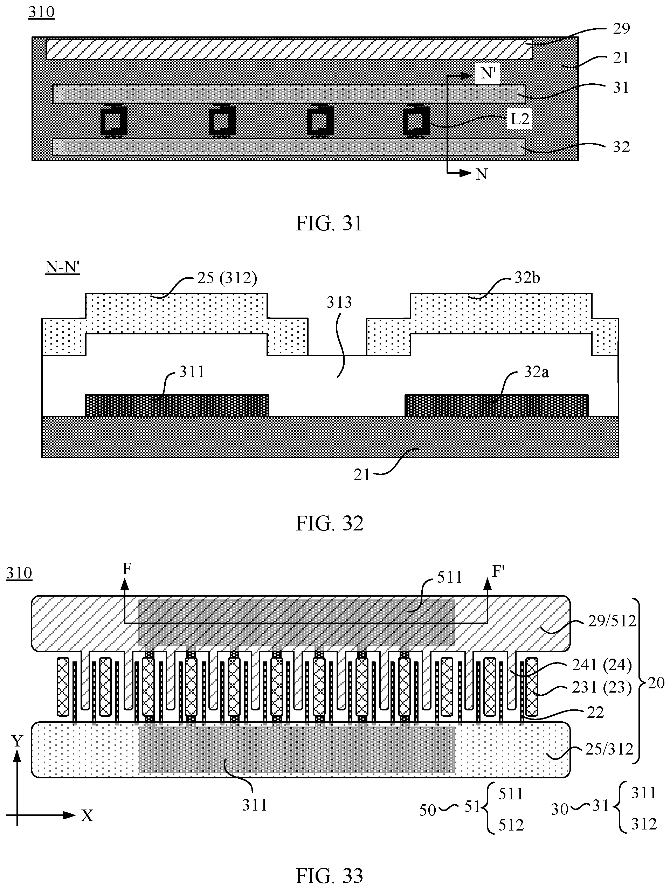

In some other embodiments, as shown in FIG. 31, the first matching circuit 30 further includes a second capacitor 32 and a second inductor L2, where both the second capacitor 32 and the second inductor L2 are located on a side that is of the epitaxial layer 21 and that is away from the substrate 10. As shown in FIG. 32, the second capacitor 32 includes a third electrode plate 32a and a fourth electrode plate 32b that are disposed opposite to each other, and the fourth electrode plate 32b is located on a side that is of the third electrode plate 32a and that is away from the substrate 10. The third electrode plate 32a of the second capacitor 32 is grounded, and the fourth electrode plate 32b of the second capacitor 32 is connected to the second electrode plate 312 of the first capacitor 31 through the second inductor L2.

A quantity of second capacitors 32 and a quantity of second inductors L2 in the first matching circuit 30 are not limited in embodiments of this application, and may be designed according to an actual requirement. In FIG. 31, an example in which the first matching circuit 30 includes one second capacitor 32 and four second inductors L2 is used for illustration.

In this way, the first capacitor 31, the second capacitor 32, and the second inductor L2 in the first matching circuit 30 are all disposed on the epitaxial layer 21. Not only a bonding wire does not need to be disposed between the first capacitor 31 and the gate 22, but also a bonding wire does not need to be disposed between the second capacitor 32 and the first capacitor 31, so that parasitic inductance and parasitic capacitance between the first capacitor 31 and the gate 22 may be small, parasitic inductance and parasitic capacitance between the second capacitor 32 and the first capacitor 31 may be small, and parasitic capacitance and parasitic inductance in the integrated circuit 310 may be small. This may further enhance output power and efficiency of the integrated circuit 310, and improve consistency of high and low frequency performance of the integrated circuit 310.

In addition, the parasitic inductance and the parasitic capacitance between the first capacitor 31 and the gate 22 are small, and the parasitic inductance and the parasitic capacitance between the second capacitor 32 and the first capacitor 31 are also small. In this way, signal transmission between the first capacitor 31 and the gate 22 and between the first capacitor 31 and the second capacitor 32 may be fast. This can mitigate a signal delay, and increase a signal transmission speed of the integrated circuit 310.

In addition, the first capacitor 31, the second capacitor 32, and the second inductor L2 in the first matching circuit 30 are all disposed on the epitaxial layer 21. This can further improve stability of a connection between the first capacitor 31 and the gate 22, a connection between the first capacitor 31 and the second inductor L2, and a connection between the second capacitor 32 and the second inductor L2, thereby enhancing use stability of the integrated circuit 310.

Certainly, no bonding wire needs to be disposed between the first capacitor 31 and the gate 22, and no bonding wire needs to be disposed between the second capacitor 32 and the first capacitor 31. This can further reduce costs, reduce a packaging area of the integrated circuit 310, shorten a packaging cycle of the integrated circuit 310, and improve packaging efficiency of the integrated circuit 310.

A structure of the second inductor L2 may be similar to a structure of the first inductor L1. For the structure of the second inductor L2, refer to FIG. 27, FIG. 28, and FIG. 29, and the foregoing descriptions about the structure of the first inductor L1. Details are not described herein again.

Different from that in the first inductor L1, the first conductive pattern N1 in the second inductor L2 may be disposed at a same layer as the first electrode plate 311 of the first capacitor 31, and the second conductive pattern N2 in the second inductor L2 may be disposed at a same layer as the second electrode plate 312 of the first capacitor 31. In this way, in one aspect, a fabrication process of the first matching circuit 30 can be simplified, and fabrication efficiency of the first matching circuit 30 can be improved. In another aspect, the second inductor L2 can be conveniently connected to the first capacitor 31, and a connection structure between the second inductor L2 and the first capacitor 32 can be simplified.

In some examples, as shown in FIG. 32, the third electrode plate 32a of the second capacitor 32 is disposed at a same layer as the first electrode plate 311 of the first capacitor 31, and the fourth electrode plate 32b of the second capacitor 32 is disposed at a same layer as the second electrode plate 312 of the first capacitor 31.

In this way, in a process of fabricating the first matching circuit 30, the first electrode plate 311 of the first capacitor 31 and the third electrode plate 32a of the second capacitor 32 may be fabricated synchronously, and the second electrode plate 312 of the first capacitor 31 and the fourth electrode plate 32b of the second capacitor 32 may be fabricated synchronously. This can simplify a process of fabricating the first matching circuit 30, improve fabrication efficiency of the first matching circuit 30, and reduce fabrication costs of the first matching circuit 30.

A shape of a projection of the third electrode plate 32a of the second capacitor 32 on the substrate 10 and a shape of a projection of the fourth electrode plate 32b of the second capacitor 32 on the substrate 10 are not limited in embodiments of this application, and may be designed according to an actual requirement. Similarly, sizes of projection areas of the third electrode plate 32a and the fourth electrode plate 32b of the second capacitor 32 on the substrate 10, and an overlapping area between the projection of the third electrode plate 32a on the substrate 10 and the projection of the fourth electrode plate 32b on the substrate 10 are not limited in embodiments of this application.

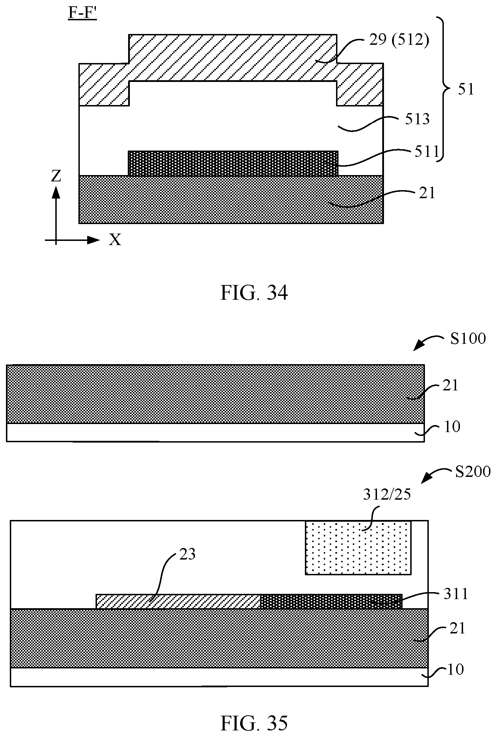

In some embodiments, as shown in FIG. 33 and FIG. 34, the HEMT device 20 further includes a fourth pad 29, where the fourth pad 29 is located on a side that is of the epitaxial layer 21 and that is away from the substrate 10, the first electrode 23 is located between the first pad 25 and the fourth pad 29, and the fourth pad 29 is connected to the second electrode 24. The integrated circuit 310 further includes a second matching circuit 50, where the second matching circuit 50 includes a third capacitor 51, and the third capacitor 51 is located on a side that is of the epitaxial layer 21 and that is away from the substrate 10. The third capacitor 51 includes a fifth electrode plate 511 and a sixth electrode plate 512 that are disposed opposite to each other, and the sixth electrode plate 512 is located on a side that is of the fifth electrode plate 511 and that is away from the substrate 10. The fifth electrode plate 511 of the third capacitor 51 is grounded, and the sixth electrode plate 512 of the third capacitor 51 is connected to the second electrode 24.

As shown in FIG. 34, the third capacitor may further include a second dielectric layer 513, and the second dielectric layer 513 is located between the fifth electrode plate 511 and the sixth electrode plate 512.

A shape and a size of a projection of the fourth pad 29 on the substrate 10 are not limited in embodiments of this application. For example, the shape of the projection of the fourth pad 29 on the substrate 10 may be a rectangle, and the fourth pad 29 may extend in a first direction X.

As shown in FIG. 33, the HEMT device 20 may include a plurality of second electrodes 24, and the plurality of second electrodes 24 may all be connected to the fourth pad 29.

It may be understood that, in addition to the third capacitor 51, the second matching circuit 50 provided in this embodiment of this application may further include another component.

In this embodiment of this application, the HEMT device 20 is connected to the second matching circuit 50, the third capacitor 51 of the second matching circuit 50 is disposed on the epitaxial layer 21 of the HEMT device 20, the third capacitor 51 includes the fifth electrode plate 511 and the sixth electrode plate 512, the fifth electrode plate 511 is grounded, and the sixth electrode plate 512 is connected to the second electrode 24 of the HEMT device 20. In this way, no bonding wire needs to be disposed between the third capacitor 51 in the second matching circuit 50 and the second electrode 24, so that parasitic inductance and parasitic capacitance between the third capacitor 51 and the second electrode 24 are small, and parasitic capacitance and parasitic inductance in the integrated circuit 310 are small. This helps enhance output power and efficiency of the integrated circuit 310, and improve consistency of high and low frequency performance of the integrated circuit 310. In addition, the parasitic inductance and the parasitic capacitance between the third capacitor 51 and the second electrode 24 are small, so that signal transmission between the third capacitor 51 and the second electrode 24 may be fast. This can mitigate a signal delay, and increase a signal transmission speed of the integrated circuit 310.

In addition, no bonding wire is disposed between the third capacitor 51 and the second electrode 24, so that stability of a connection between the third capacitor 51 and the second electrode 24 can be further improved, to further enhance use stability of the integrated circuit 310. Certainly, no bonding wire is disposed between the third capacitor 51 and the second electrode 24. This can further reduce costs, reduce a packaging area of the integrated circuit 310, shorten a packaging cycle of the integrated circuit 310, and improve packaging efficiency of the integrated circuit 310.

In some embodiments, as shown in FIG. 33 and FIG. 34, the fourth pad 29 may be used as the sixth electrode plate 512 of the third capacitor 51. In this way, the sixth electrode plate 512 of the third capacitor 51 is directly connected to the second electrode 24, and no connection wire needs to be disposed between the third capacitor 51 and the third capacitor 51. This further helps simplify the structure of the integrated circuit 310 and reduce costs of the integrated circuit 310.

When the fourth pad 29 is used as the sixth electrode plate 512 of the third capacitor 51, the fifth electrode plate 511 of the third capacitor 51 may be disposed at a same layer as the first electrode 23, and the fifth electrode plate 511 of the third capacitor 51 may be further disposed at a same layer as the gate 22. Certainly, the first electrode plate 311 of the first capacitor 31 may alternatively not be disposed at a same layer as the gate 22 and the first electrode 23. In this case, the fifth electrode plate 511 of the third capacitor 51 may be fabricated separately.

It may be understood that, a disposing position of the third capacitor 51 is not limited in embodiments of this application.

An embodiment of this application further provides a method for fabricating an integrated circuit. As shown in FIG. 35, the fabrication method includes step S100 and step S200.

S100: As shown in FIG. 35, form an epitaxial layer 21 on a substrate 10.

For example, a material of the substrate 10 may include silicon carbide, silicon, sapphire, diamond, and the like.

For example, the epitaxial layer 21 may include a channel layer and a barrier layer that are stacked, and the barrier layer is located on a side that is of the channel layer and that is away from the substrate. A material of the channel layer is different from a material of the barrier layer, so that a heterojunction may be formed, and a two-dimensional electron gas may be generated through polarization.

A method for forming the epitaxial layer 21 may be, for example, a metal-organic chemical vapor deposition (metal-organic chemical vapor deposition, MOCVD) growth method or a molecular beam epitaxy (molecular beam epitaxy, MBE) growth method.

S200: As shown in FIG. 5 and FIG. 35, form a gate 22, a first electrode 23, a second electrode 24, a first pad 25, and a first capacitor 31 on a side that is of the epitaxial layer 21 and that is away from the substrate 10. The gate 22 is located between the first electrode 23 and the second electrode 24, and the gate 22 is connected to the first pad 25. The first capacitor 31 includes a first electrode plate 311 and a second electrode plate 312 that are disposed opposite to each other, the second electrode plate 312 is located on a side that is of the first electrode plate 311 and that is away from the substrate 10, the first electrode plate 311 of the first capacitor 31 is grounded, and the second electrode plate 312 of the first capacitor 31 is connected to the gate 22.

It may be understood that the epitaxial layer 21, the gate 22, the first electrode 23, the second electrode 24, and the first pad 25 all belong to the HEMT device 20, and the first capacitor 31 belongs to the first matching circuit 30.

For example, the gate 22, the first electrode 23, the second electrode 24, the first pad 25, and the first capacitor 31 may be formed on the side that is of the epitaxial layer 21 and that is away from the substrate 10 by using a process like a metal deposition process, a sputtering process, a vapor deposition process, an electroplating process, or an etching process.

In some examples, the first electrode 23 and the second electrode 24 may be first formed on the side that is of the epitaxial layer 21 and that is away from the substrate 10, then the gate 22 is formed, and finally the first pad 25 is formed.

When positions of the first capacitor 31 are different, forming processes of the first capacitor 31 are also different. For example, in FIG. 35, the first pad 25 is used as the second electrode plate 312 of the first capacitor 31, and the first electrode plate 311 of the first capacitor 31 and the first electrode 23 are disposed at a same layer and are connected to each other. In this case, the first electrode plate 311 of the first capacitor 31 may be fabricated synchronously with the first electrode 23. When the first pad 25 is fabricated, the second electrode plate 312 of the first capacitor 31 is also fabricated.

Beneficial effects that can be achieved by the fabrication method for the integrated circuit provided in this embodiment of this application are the same as the beneficial effects that can be achieved by the integrated circuit provided in any one of the foregoing embodiments. Details are not described herein again.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An integrated circuit, comprising:
a substrate;
an HEMT device, located on the substrate, wherein the HEMT device comprises an epitaxial layer, a gate, a first electrode, a second electrode, and a first pad, wherein the gate, the first electrode, the second electrode, and the first pad are all located on a side that is of the epitaxial layer and that is away from the substrate, the gate is located between the first electrode and the second electrode, and the gate is connected to the first pad; and
a first matching circuit, comprising a first capacitor, wherein the first capacitor is located on the side that is of the epitaxial layer and that is away from the substrate; and the first capacitor comprises a first electrode plate and a second electrode plate that are disposed opposite to each other, the second electrode plate is located on a side that is of the first electrode plate and that is away from the substrate, the first electrode plate of the first capacitor is grounded, and the second electrode plate of the first capacitor is connected to the gate.

2. The integrated circuit according to claim 1, wherein the first pad is used as the second electrode plate of the first capacitor.

3. The integrated circuit according to claim 2, wherein the HEMT device further comprises a second pad, the second pad is located on the side that is of the epitaxial layer and that is away from the substrate, and the gate is further connected to the second pad; and the first pad is located between the first electrode and the second pad.

4. The integrated circuit according to claim 2, wherein the HEMT device further comprises a third pad, the third pad is located on the side that is of the epitaxial layer and that is away from the substrate, and the third pad is located between the first electrode and the first pad; and the third pad connects the gate and the first pad.

5. The integrated circuit according to claim 1, wherein the HEMT device comprises a plurality of first electrodes, and the plurality of first electrodes are arranged in a first direction parallel to the substrate; and the first capacitor is located between two adjacent first electrodes.

6. The integrated circuit according to claim 1, wherein the integrated circuit comprises a plurality of HEMT devices, the plurality of HEMT devices are arranged in a first direction parallel to the substrate, and the first capacitor is located between two adjacent HEMT devices; and the second electrode plate of the first capacitor is connected to first pads of the two adjacent HEMT devices.

7. The integrated circuit according to claim 1, wherein the first electrode is used as the first electrode plate of the first capacitor.

8. The integrated circuit according to any one of claims 1 to 6, wherein the first electrode plate of the first capacitor is connected to the first electrode.

9. The integrated circuit according to claim 8, wherein the first electrode plate of the first capacitor comprises a main body part and an extension part that are perpendicular to each other, and the extension part connects the main body part and the first electrode; at least a portion of a projection of the main body part on the substrate overlaps a projection of the second electrode plate on the substrate; and at least a portion of a projection of the extension part on the substrate is located outside the projection of the second electrode plate on the substrate.

10. The integrated circuit according to any one of claims 1 to 9, further comprising:
a conductive layer, located on a side that is of the substrate and that is away from the HEMT device, wherein the conductive layer penetrates the substrate and the epitaxial layer, and is connected to the first electrode plate of the first capacitor.

11. The integrated circuit according to claim 10, wherein the first electrode plate of the first capacitor comprises a first sublayer and a second sublayer that are stacked, the second sublayer is located on a side that is of the first sublayer and that is away from the substrate, and the first sublayer is in direct contact with the second sublayer; and
the first sublayer is disposed at a same layer as the first electrode, and a material of the first sublayer is the same as a material of the first electrode.

12. The integrated circuit according to any one of claims 1 to 11, wherein the HEMT device further comprises:
a first inductor, located on the side that is of the epitaxial layer and that is away from the substrate, wherein the first inductor connects the gate and the first pad.

13. The integrated circuit according to claim 12, wherein the HEMT device comprises a plurality of gates, the plurality of gates are arranged in the first direction parallel to the substrate, and the first inductor is connected to the plurality of gates.

14. The integrated circuit according to claim 12 or 13, wherein
the first inductor comprises a first trace segment and a second trace segment, and a projection of the first trace segment on the substrate intersects with a projection of the second trace segment on the substrate; the second trace segment comprises a first sub-segment, a second sub-segment, and a third sub-segment that are sequentially connected, the first sub-segment and the third sub-segment each comprise a first conductive pattern and a second conductive pattern that are stacked, and the second conductive pattern is located on a side that is of the first conductive pattern and that is away from the substrate and is connected to the first conductive pattern; and one of the first trace segment and the second sub-segment comprises a first conductive pattern, and the other comprises a second conductive pattern.

15. The integrated circuit according to claim 14, wherein the first conductive pattern is disposed at a same layer as the first electrode, and the second conductive pattern is disposed at a same layer as the first pad.

16. The integrated circuit according to any one of claims 1 to 15, wherein
the first matching circuit further comprises a second capacitor and a second inductor, both the second capacitor and the second inductor are located outside the substrate, and the second inductor connects the second capacitor and the first capacitor.

17. The integrated circuit according to any one of claims 1 to 15, wherein
the first matching circuit further comprises a second capacitor and a second inductor, and both the second capacitor and the second inductor are located on the side that is of the epitaxial layer and that is away from the substrate; the second capacitor comprises a third electrode plate and a fourth electrode plate that are disposed opposite to each other, and the fourth electrode plate is located on a side that is of the third electrode plate and that is away from the substrate; and the third electrode plate of the second capacitor is grounded, and the fourth electrode plate of the second capacitor is connected to the second electrode plate of the first capacitor through the second inductor.

18. The integrated circuit according to claim 17, wherein the third electrode plate of the second capacitor is disposed at a same layer as the first electrode plate of the first capacitor, and the fourth electrode plate of the second capacitor is disposed at a same layer as the second electrode plate of the first capacitor.

19. The integrated circuit according to any one of claims 1 to 18, wherein the HEMT device further comprises a fourth pad, and the fourth pad is located on the side that is of the epitaxial layer and that is away from the substrate; and the first electrode is located between the first pad and the fourth pad, and the fourth pad is connected to the second electrode; and
the integrated circuit further comprises a second matching circuit, the second matching circuit comprises a third capacitor, and the third capacitor is located on the side that is of the epitaxial layer and that is away from the substrate; the third capacitor comprises a fifth electrode plate and a sixth electrode plate that are disposed opposite to each other, and the sixth electrode plate is located on a side that is of the fifth electrode plate and that is away from the substrate; and the fifth electrode plate of the third capacitor is grounded, and the sixth electrode plate of the third capacitor is connected to the second electrode.

20. A method for fabricating an integrated circuit, comprising:
forming an epitaxial layer on a substrate; and
forming a gate, a first electrode, a second electrode, a first pad, and a first capacitor on a side that is of the epitaxial layer and that is away from the substrate, wherein the gate is located between the first electrode and the second electrode, and the gate is connected to the first pad; and the first capacitor comprises a first electrode plate and a second electrode plate that are disposed opposite to each other, the second electrode plate is located on a side that is of the first electrode plate and that is away from the substrate, the first electrode plate of the first capacitor is grounded, and the second electrode plate of the first capacitor is connected to the gate.

21. A power amplifier circuit, comprising:
a package structure; and
the integrated circuit according to any one of claims 1 to 19, wherein the integrated circuit is packaged inside the package structure.

22. An electronic device, comprising a power amplifier and an antenna, wherein the power amplifier is configured to: amplify a radio frequency signal and then output the amplified radio frequency signal to the antenna for radiation, and the power amplifier comprises the power amplifier circuit according to claim 21.
